(19) Europäisches Patentamt

European Patent Office

Office européen des brevets

(11) **EP 3 009 853 B1**

(12) **FASCICULE DE BREVET EUROPEEN**

(45) Date de publication et mention
de la délivrance du brevet:
**24.05.2017 Bulletin 2017/21**

(51) Int Cl.:
*G01R 33/00* *(2006.01)*    *G01R 33/02* *(2006.01)*
*G01R 33/09* *(2006.01)*

(21) Numéro de dépôt: **15189467.2**

(22) Date de dépôt: **13.10.2015**

(54) **CAPTEUR DE CHAMP MAGNETIQUE POUR LA DETECTION D'AU MOINS DEUX COMPOSANTES DE CHAMP MAGNETIQUE**

MAGNETFELDSENSOR ZUR ERFASSUNG VON MINDESTENS ZWEI KOMPONENTEN EINES MAGNETFELDS

MAGNETIC FIELD SENSOR FOR DETECTING AT LEAST TWO MAGNETIC FIELD COMPONENTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.10.2014 FR 1459950**

(43) Date de publication de la demande:
**20.04.2016 Bulletin 2016/16**

(73) Titulaires:
* **Commissariat à l'énergie atomique et aux énergies alternatives
  75015 Paris (FR)**
* **Centre National de la Recherche Scientifique CNRS
  75794 Paris Cedex 16 (FR)**

(72) Inventeurs:
* **DIENY, Bernard
  38250 Villars De Lans (FR)**
* **JOISTEN, Hélène
  38000 Grenoble (FR)**
* **SABON, Philippe
  38420 Moirans (FR)**

(74) Mandataire: **Cabinet Camus Lebkiri
25 rue de Maubeuge
75009 Paris (FR)**

(56) Documents cités:
**US-A1- 2011 309 829     US-A1- 2014 021 571**

* **SILEO L ET AL: "Fully integrated three-axis Hall magnetic sensor based on micromachined structures", MICROELECTRONIC ENGINEERING, ELSEVIER PUBLISHERS BV., AMSTERDAM, NL, vol. 87, no. 5-8, 1 mai 2010 (2010-05-01), pages 1217-1219, XP026945412, ISSN: 0167-9317, DOI: 10.1016/J.MEE.2009.11.160 [extrait le 2009-12-03]**

**Description**

**DOMAINE TECHNIQUE DE L'INVENTION**

Le domaine technique de l'invention est celui des capteurs de champ magnétique. Un aspect de la présente invention concerne un capteur de champ magnétique pour la détection d'au moins deux composantes de champ magnétique. Un autre aspect de la présente invention concerne un capteur de champ magnétique pour la détection d'au moins trois composantes de champ magnétique. Un autre aspect de la présente invention concerne un procédé de fabrication d'un capteur de champ magnétique pour la détection d'au moins trois composantes de champ magnétique.

**ARRIERE-PLAN TECHNOLOGIQUE DE L'INVENTION**

Les capteurs de champ magnétique à deux dimensions (2D) ou trois dimensions (3D) suscitent un fort intérêt pour de vastes domaines d'application tels que l'industrie automobile, avionique ou spatiale, les systèmes mobiles ou embarqués, la téléphonie mobile, le domaine des ordinateurs portables, de la pétrochimie, de l'environnement ou du biomédical, etc. Des solutions nouvelles sont recherchées afin d'obtenir des capteurs de champ magnétique 2D ou 3D avec les propriétés suivantes :

- grande sensibilité selon chaque dimension,
- faible consommation énergétique,
- faible masse, grande légèreté,
- miniaturisation pour un encombrement minimal,
- facilité de fabrication collective pour une production en masse à relativement faibles coûts,
- facilité d'utilisation.

En effet, les capteurs de champ magnétique 2D ou 3D existants présentent des limitations concernant leurs performances ou leurs techniques de fabrication.

Un capteur de champ magnétique 2D ou 3D permet la mesure directionnelle du champ magnétique B par la mesure, simultanée et sans avoir à réorienter le capteur dans l'espace, de deux ou trois composantes du champ magnétique B. Un capteur de champ magnétique 3D permet ainsi, par la mesure simultanée de trois composantes ($B_x$, $B_y$, $B_z$) du champ magnétique B dans l'espace, de réaliser une cartographie du vecteur de champ magnétique dans la région explorée, c'est-à-dire dans une gamme de champ donnée : il peut s'agir d'une cartographie des variations du vecteur de champ magnétique dans l'espace, ou d'une cartographie des variations du vecteur de champ magnétique dans le temps, éventuellement à haute fréquence. On souhaite typiquement qu'un capteur de champ magnétique 2D ou 3D ait la même sensibilité de mesure sur ses différentes dimensions et soit aussi sensible, sur chacune de ses dimensions, qu'un capteur de champ magnétique uniaxial. Les capteurs de champ magnétique uniaxiaux existants sont par exemple des capteurs à magnétorésistance géante GMR (de l'anglais « giant magnetoresistance »), des capteurs à anisotropie de magnétorésistance AMR (de l'anglais « anisotropic magnetoresistance »), des capteurs à magnétorésistance tunnel TMR (de l'anglais « tunnel magnetoresistance ») ou des capteurs microfluxgates. De tels capteurs sont parfois appelés « capteurs vectoriels » car ils mesurent une composante vectorielle du champ magnétique appliqué.

Selon les cas, les champs magnétiques ambiants à mesurer peuvent provenir de sources locales de courants ou de matériaux magnétiques tels que des aimants. Il peut également s'agir de mesurer le champ magnétique terrestre ou spatial, ou de mesurer des champs créés par des organismes vivants. D'une manière générale, les champs magnétiques à mesurer ont typiquement de faibles amplitudes et/ou de faibles variations que l'on souhaite détecter. Les gammes de mesure souhaitées peuvent être très variées. Un fort champ à mesurer peut parfois être supérieur au Tesla T. Plus couramment, les champs à mesurer sont de l'ordre du millitesla mT, du microtesla $\mu$T (ainsi le champ terrestre local est de l'ordre de 50 $\mu$T environ) ou du nanotesla nT. Les champs à mesurer peuvent également être de l'ordre du picotesla pT ou du femtotesla fT, etc. Un objectif peut par exemple être de mesurer en trois dimensions de faibles variations du champ terrestre, par exemple de l'ordre du nT, ou de très faibles valeurs du champ magnétique dans l'espace. Certains domaines comme le spatial, la géomagnétométrie ou la biomagnétométrie nécessitent en particulier des capteurs de champ magnétique ayant de hautes performances de sensibilité.

Les capteurs magnétiques uniaxiaux, ou capteurs magnétiques monoaxiaux, tels que les capteurs GMR, sont connus pour la mesure de l'amplitude du champ magnétique sur l'axe du capteur. Les capteurs magnétiques uniaxiaux sont typiquement réalisés à la surface d'un substrat par des techniques de microélectronique.

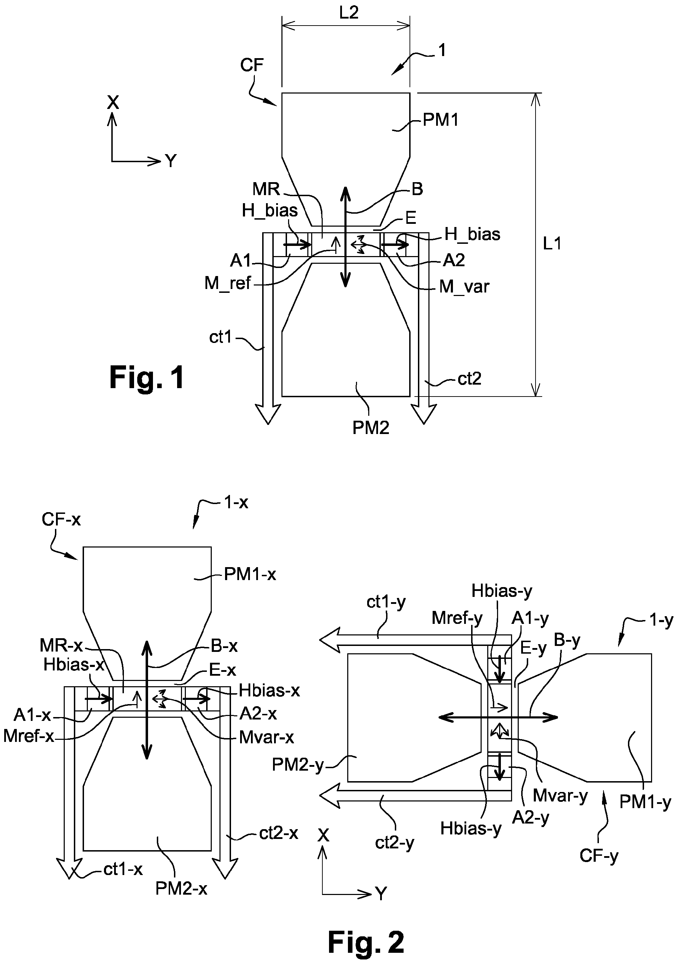

La figure 1 montre à titre d'exemple un capteur uniaxial GMR 1 selon l'état de la technique. Un tel capteur uniaxial GMR est également appelé « spin-valve » ou « vanne de spin ».

Le capteur uniaxial GMR 1 comporte un concentrateur de flux CF qui comprend une première pièce magnétique PM1 et une deuxième pièce magnétique PM2. La première pièce magnétique PM1 et la deuxième pièce magnétique PM2 sont séparées par un entrefer E. Dans l'exemple de la figure 1, le concentrateur de flux F présente une dimension L1, dite « grande dimension », suivant un axe X et une dimension L2, dite « petite dimension », suivant un axe Y. L'axe Y est perpendiculaire à l'axe X. Le concentrateur de flux F permet de capter le flux magnétique qui est créé par le champ B à mesurer dans la direction X de sa grande dimension L1, et d'amplifier ce champ B à mesurer au niveau d'un élément magnétorésistif MR. L'élément magnétorésistif MR est typiquement inséré dans l'entrefer E du concentrateur de flux F. Les première et deuxième pièces magnétiques PM1 et PM2 du concentrateur de flux F sont réalisées en un matériau doux, qui est typiquement du permalloy.

L'élément magnétorésistif MR du capteur uniaxial GMR 1 permet de transformer une variation de champ magnétique en une variation de résistance électrique, qui est mesurée grâce à deux contacts électriques ct1 et ct2. Dans le cas du capteur uniaxial GMR 1, l'élément magnétorésistif MR est une vanne de spin qui utilise le phénomène de magnétorésistance géante. Alternativement, d'autres types de capteurs uniaxiaux peuvent utiliser un élément magnétorésistif qui est une jonction tunnel magnétique. Une vanne de spin est notamment constituée d'une couche magnétique dont la direction d'aimantation Mref est piégée, appelée « couche de référence », et d'une couche magnétique dont la direction d'aimantation Mvar est variable, appelée « couche douce ». La direction de l'aimantation Mvar de la couche douce tourne facilement sous l'influence d'un champ B à mesurer. La couche de référence et la couche douce sont séparées par une couche non-magnétique qui est typiquement en cuivre. Le piégeage de la couche de référence est en général réalisé par interaction avec une couche antiferromagnétique adjacente à la couche de référence, par un mécanisme d'anisotropie d'échange. La couche antiferromagnétique n'est pas représentée sur la figure 1. Alternativement, la couche de référence peut être une couche antiferromagnétique synthétique comportant deux couches ferromagnétiques couplées antiparallèlement à travers une fine couche de couplage antiparallèle souvent en ruthénium d'épaisseur inférieure à 1 nm. Cette couche antiferromagnétique synthétique peut elle-même être piégée par interaction avec une autre couche antiferromagnétique. Dans l'exemple de la figure 1, la direction d'aimantation Mref de la couche de référence est parallèle au champ B à mesurer, c'est-à-dire parallèle à l'axe X, et en champ nul, la direction d'aimantation Mvar de la couche douce est transverse au champ B à mesurer, c'est-à-dire parallèle à l'axe Y. Dans le cas du capteur uniaxial GMR 1 utilisant une vanne de spin, les contacts électriques ct1 et ct2 sont agencés de part et d'autre de l'élément magnétorésistif MR, c'est-à-dire de part et d'autre de la vanne de spin, de manière qu'un courant électrique puisse circuler dans le plan des couches : il s'agit d'une configuration CIP (de l'anglais « Current In Plane ») connue. Dans le cas alternatif d'un capteur uniaxial utilisant une jonction tunnel magnétique, les contacts électriques ct1 et ct2 sont pris l'un sous l'empilement des couches et l'autre sur l'empilement des couches de manière qu'un courant électrique puisse traverser la jonction tunnel magnétique perpendiculairement à la barrière tunnel.

Le champ magnétique rayonné dans l'entrefer E qui sépare les deux pièces magnétiques du concentrateur de flux F est très faible lorsque le champ appliqué est nul. En revanche, lorsque le champ est appliqué suivant la grande dimension L1 du concentrateur de flux CF, le matériau doux des pièces magnétiques PM1 et PM2 se polarise magnétiquement parallèlement au champ et créé un fort champ rayonné dans l'entrefer E du concentrateur de flux CF où est agencé l'élément magnétorésistif MR. Sous l'effet du champ B à mesurer, la direction d'aimantation Mvar de la couche douce de l'élément magnétorésistif MR tourne et se rapproche soit de l'alignement parallèle, soit de l'alignement antiparallèle par rapport à la direction d'aimantation Mref de la couche de référence. Lorsque l'élément magnétorésistif MR est parcouru par un courant électrique, il en résulte une tension aux bornes de l'élément magnétorésistif MR qui varie en fonction du champ B appliqué sur l'élément magnétorésistif MR. Dans le cas du capteur uniaxial GMR 1, la résistance de la vanne de spin varie comme le cosinus de l'angle entre la direction d'aimantation Mref de la couche de référence et la direction d'aimantation Mvar de la couche douce. Dans le cas alternatif d'un capteur uniaxial utilisant une jonction tunnel magnétique, c'est la conductance de la jonction tunnel magnétique qui varie comme le cosinus de l'angle entre la direction d'aimantation Mref de la couche de référence et la direction d'aimantation Mvar de la couche douce.

Toujours dans le cas d'une mesure uniaxe, la direction de mesure étant définie par la grande dimension L1 du concentrateur de flux, on dispose de part et d'autre de l'élément magnétorésistif MR un premier aimant permanent A1 et un deuxième aimant permanent A2. Les premier et deuxième aimants permanents A1 et A2 sont typiquement réalisés en un matériau magnétique dur et créent un champ Hbias qui polarise la direction d'aimantation Mvar de la couche douce transversalement à la direction du champ à mesurer. On s'assure ainsi que la direction d'aimantation Mvar de la couche douce en champ nul est monodomaine et polarisée transversalement à la direction du champ à mesurer. Le champ transverse Hbias n'est pas trop grand afin de ne pas diminuer trop la sensibilité du capteur. Aux extrémités de l'élément magnétorésistif MR en contact avec chaque aimant permanent, le champ transverse Hbias est typiquement de l'ordre de 0,1 à 1 fois la valeur maximum du champ que l'on cherche à mesurer. Le champ transverse Hbias est plus faible au centre de l'élément magnétorésistif MR qu'à ses extrémités, en raison d'un plus grand éloignement par rapport aux aimants permanents. Le champ transverse Hbias permet de diminuer significativement le bruit du capteur en évitant la formation de structures magnétiques complexes dans la couche sensible.

Un capteur de champ magnétique 2D peut typiquement être obtenu en plaçant à la surface d'un substrat un premier capteur uniaxial ayant un premier axe de mesure et un deuxième capteur uniaxial ayant un deuxième axe de mesure, le deuxième axe de mesure formant un angle non nul, généralement 90°, avec le premier axe de mesure. Une telle réalisation avec deux orientations différentes de capteurs magnétiques est obtenue par des procédés de microélectronique. Toutefois, la fabrication d'un capteur de champ magnétique 2D de type GMR ou TMR par association de deux capteurs monoaxiaux orthogonaux à la surface d'un substrat impose dans l'état de l'art une certaine complexité technologique.

La figure 2 montre à titre d'exemple un capteur de champ magnétique 2D selon l'état de la technique, comportant un premier capteur uniaxial 1-x d'axe de mesure X et un deuxième capteur uniaxial 1-y d'axe de mesure Y. Le premier capteur 1-x d'axe de mesure X permet de mesurer une première composante B-x d'un champ magnétique appliqué et le deuxième capteur 1-y d'axe de mesure Y permet de mesurer une deuxième composante B-y du champ magnétique appliqué.

De manière analogue à ce qui a précédemment été décrit, le premier capteur 1-x comporte :

- un concentrateur de flux CF-x comportant une première pièce magnétique PM1-x, une deuxième pièce magnétique PM2-x et un entrefer E-x séparant les première et deuxième pièces magnétiques ;
- un élément magnétorésistif MR-x comportant une couche de référence dont la direction d'aimantation Mref-x est fixe suivant l'axe X et une couche douce dont la direction d'aimantation Mvar-x est variable ;
- un premier aimant permanent A1-x et un deuxième aimant permanent A2-x créant un champ transverse Hbias-x qui polarise la direction d'aimantation Mvar-x de la couche douce transversalement à la direction d'aimantation Mref-x de la couche de référence, c'est-à-dire suivant l'axe Y ;
- un premier contact électrique ct1-x et un deuxième contact électrique ct2-x.

Le deuxième capteur 1-y comporte :

- un concentrateur de flux CF-y comportant une première pièce magnétique PM1-y, une deuxième pièce magnétique PM2-y et un entrefer E-y séparant les première et deuxième pièces magnétiques ;
- un élément magnétorésistif MR-y comportant une couche de référence dont la direction d'aimantation Mref-y est fixe suivant l'axe Y et une couche douce dont la direction d'aimantation Mvar-y est variable ;
- un premier aimant permanent A1-y et un deuxième aimant permanent A2-y créant un champ transverse Hbias-y qui polarise la direction d'aimantation Mvar-y de la couche douce transversalement à la direction d'aimantation Mref-y de la couche de référence, c'est-à-dire suivant l'axe X ;
- un premier contact électrique ct1-y et un deuxième contact électrique ct2-y.

Le fait que l'axe de mesure de l'élément magnétorésistif MR-x du premier capteur 1-x forme un angle, typiquement de 90°, avec l'axe de mesure de l'élément magnétorésistif MR-y du deuxième capteur 1-y impose de piéger différemment la direction d'aimantation Mref-x de la couche de référence du premier capteur 1-x d'une part, et la direction d'aimantation Mref-y de la couche de référence du deuxième capteur 1-y d'autre part. Cela impose également de polariser différemment la direction d'aimantation Mvar-x de la couche douce du premier capteur 1-x d'une part, et la direction d'aimantation Mvar-y de la couche douce du deuxième capteur 1-y d'autre part. Dans l'exemple de la figure 2, il s'agit donc de piéger la direction d'aimantation Mref-x de la couche de référence du premier capteur 1-x suivant l'axe X, et de piéger la direction d'aimantation Mref-y de la couche de référence du deuxième capteur 1-y suivant l'axe Y. Toujours dans l'exemple de la figure 2, il s'agit de polariser la direction d'aimantation Mvar-x de la couche douce du premier capteur 1-x suivant l'axe Y, et de polariser la direction d'aimantation Mvar-y de la couche douce du deuxième capteur 1-y suivant l'axe X. Or cette double contrainte - piéger différemment les directions d'aimantation des couches de référence et polariser différemment les directions d'aimantation des couches douces - complexifie beaucoup la technologie de fabrication d'un tel capteur de champ magnétique 2D.

En effet, le piégeage de la direction d'aimantation d'une couche de référence d'une vanne de spin s'effectue typiquement par un recuit et un refroidissement sous champ de la vanne de spin depuis la température de blocage de la couche antiferromagnétique de piégeage de la couche de référence. Orienter les directions d'aimantation d'une première couche de référence et d'une deuxième couche de référence selon deux directions différentes requiert donc que la température de blocage de la couche antiferromagnétique de piégeage de la première couche de référence soit différente de la température de blocage de la couche antiferromagnétique de piégeage de la deuxième couche de référence. La première couche de référence peut par exemple avoir une couche antiferromagnétique IrMn, tandis que la deuxième couche de référence a une couche antiferromagnétique PtMn. Mais cela implique que les deux capteurs uniaxiaux du capteur de champ magnétique 2D ne peuvent pas être fabriqués en une seule étape technologique, et doivent au contraire être fabriqués en des étapes technologiques différentes. La fabrication est donc complexifiée et les coûts de fabrication sont augmentés. Une autre possibilité est d'appliquer des champs locaux différents sur les deux capteurs uniaxiaux pendant le recuit. Cela ne peut pas être fait avec des aimants macroscopiques et nécessite typiquement l'ajout d'une ligne conductrice coudée passant au-dessus des deux capteurs uniaxiaux et dans laquelle on fait circuler un courant durant le recuit et le refroidissement. Ce courant génère un champ dans deux directions orthogonales si la ligne présente un coude adéquatement agencé par rapport à la position des deux capteurs uniaxiaux. Cependant, la réalisation de cette ligne conductrice coudée complexifie également la technologie de fabrication.

Par ailleurs, les aimants permanents utilisés pour polariser les directions d'aimantation des couches douces sont réalisés en matériaux magnétiques durs, de type alliages à base de Co et de Cr, ou de Sm et de Co, ou de NdFeB en couches minces. L'orientation des directions d'aimantation de ces aimants permanents est réalisée en appliquant un champ magnétique fort, c'est-à-dire au-dessus du champ coercitif du matériau, qui induit une aimantation rémanente dans la direction désirée. Ce champ magnétique fort doit toutefois être appliqué sur l'ensemble du wafer, dans la mesure où il n'y a pas de solution simple pour appliquer un champ magnétique aussi fort à une échelle locale. Dans ce cas, les directions d'aimantations des aimants permanents se retrouvent parallèles, ce qui n'est pas satisfaisant. Alternativement, certains capteurs de champ magnétique n'utilisent pas d'aimants permanents et utilisent des couches douces non polarisées, ou bien des couches douces polarisées en couplant faiblement leur direction d'aimantation à une couche antiferromagnétique. Dans ce cas, la couche de référence et la couche douce sont toutes les deux couplées à une couche antiferromagnétique : la couche de référence est fortement couplée à une première couche antiferromagnétique pour bloquer sa direction d'aimantation, tandis que la couche douce est faiblement couplée à une deuxième couche antiferromagnétique, de sorte que la deuxième couche antiferromagnétique exerce un faible champ de polarisation sur la direction d'aimantation de la couche douce, mais que la direction d'aimantation de la couche douce reste variable et peut encore tourner sous l'effet d'un champ magnétique appliqué. Dans cette configuration, pour un capteur uniaxial donné, afin d'orienter la direction d'aimantation de la couche de référence orthogonalement à la direction de polarisation de la couche douce, on utilise une première couche antiferromagnétique ayant une température de blocage différente de la température de blocage de la deuxième couche antiferromagnétique. On oriente d'abord la couche antiferromagnétique ayant la température de blocage la plus élevée, puis on fait tourner le champ appliqué de 90° avant d'orienter la couche antiferromagnétique ayant la température de blocage la moins élevée. Cependant, il n'existe pas ensuite de solution simple pour initialiser les deux capteurs uniaxiaux l'un par rapport à l'autre.Les documents suivants divulguent d'autres capteurs magnétiques avec concentrateurs de flux: US 2011/309829 A1, US 2014/021571 A1, SILEO L ET AL: "Fully integrated three-axis Hall magnetic sensor based on micromachined structures", MICROELECTRONIC ENGINEERING, ELSEVIER PUBLISHERS BV., AMSTERDAM, NL, vol. 87, no. 5-8, 1 mai 2010 (2010-05-01), pages 1217-1219.

Les difficultés liées à la fabrication d'un capteur de champ magnétique 2D, permettant la mesure d'une première composante Bx de champ magnétique et d'une deuxième composante By de champ magnétique dans le plan d'un substrat, ont été précédemment décrites. Si l'on cherche à présent à fabriquer un capteur de champ magnétique 3D, de nouvelles difficultés se présentent. En effet, la mesure d'une troisième composante Bz de champ magnétique hors du plan du substrat est beaucoup plus complexe à obtenir simultanément et avec la même précision que les première et deuxième composantes Bx et By de champ magnétique dans le plan du substrat. Pour mesurer la troisième composante avec la même sensibilité que les première et deuxième composantes, il s'agit d'utiliser un troisième capteur uniaxial hors de la surface du substrat, le troisième capteur uniaxial étant du même type que les premier et deuxième capteurs uniaxiaux à la surface du substrat. Le troisième capteur uniaxial est préférentiellement perpendiculaire à la surface du substrat. Mais d'un point de vue technologique, il n'existe pas de solution simple permettant d'obtenir un tel troisième capteur uniaxial ayant une grande sensibilité vis-à-vis de la troisième composante Bz de champ magnétique. En général, le troisième capteur uniaxial est réalisé sur un plan incliné par rapport au plan du substrat, ou est réalisé séparément puis fixé perpendiculairement au plan des premier et deuxième capteurs uniaxiaux. Dans les deux cas, le procédé de fabrication du capteur de champ magnétique 3D est rendu complexe.

## RESUME DE L'INVENTION

Dans ce contexte, l'invention a pour but d'offrir une solution aux problèmes évoqués précédemment en proposant un capteur de champ magnétique pour la détection d'au moins deux composantes de champ magnétique pouvant être obtenu par un procédé de fabrication simple et peu coûteux, les couches de référence ayant une même direction d'aimantation obtenue en une seule étape technologique.L'invention est définie par les revendications indépendante. Un aspect de l'invention concerne donc un capteur de champ magnétique pour la détection d'au moins deux composantes de champ magnétique comportant :

- un premier capteur pour la détection d'une première composante magnétique suivant une première direction X comprenant :

  ◦ un premier concentrateur de flux comportant une première pièce magnétique, une deuxième pièce magnétique et un entrefer entre les première et deuxième pièces magnétiques ;
  ◦ un premier élément magnétorésistif agencé dans l'entrefer du premier concentrateur de flux,

- un deuxième capteur pour la détection d'une deuxième composante magnétique suivant une deuxième direction Y distincte de la première direction X comprenant :

  ◦ un deuxième concentrateur de flux comportant une première pièce magnétique, une deuxième pièce magnétique et un entrefer entre les première et deuxième pièces magnétiques ;
  ◦ un deuxième élément magnétorésistif agencé dans l'entrefer du deuxième concentrateur de flux ;

  chacun des premier et deuxième éléments magnétorésistifs comportant une couche de référence ayant une direction d'aimantation fixe et une couche sensible ayant une direction d'aimantation variable, chacun des premier et deuxième éléments magnétorésistifs ayant un premier état dit « état de repos » dans lequel l'aimantation de la couche sensible a une première direction donnée, et un deuxième état dit « état excité » dans lequel l'aimantation de la couche sensible a une deuxième direction distincte de la première direction ;

  ledit capteur de champ magnétique étant tel que :

- la direction d'aimantation fixe de la couche de référence du premier élément magnétorésistif est sensiblement identique à la direction d'aimantation fixe de la couche de référence du deuxième élément magnétorésistif ;
- lorsque les premier et deuxième éléments magnétorésistifs sont dans le premier état de repos, la direction d'aimantation variable de la couche sensible du premier élément magnétorésistif est sensiblement identique à la direction d'aimantation variable de la couche sensible du deuxième élément magnétorésistif ;
- l'entrefer du premier concentrateur de flux et l'entrefer du deuxième concentrateur de flux sont orientés parallèlement à une direction XY qui est, à $\pm 15°$, et avantageusement à $\pm 5°$, la bissectrice de la première direction X et de la deuxième direction Y.

Grâce à l'invention, le premier élément magnétorésistif et le deuxième élément magnétorésistif présentent la même orientation spatiale dans le plan défini par les première et deuxième directions X et Y : le premier élément magnétorésistif et le deuxième élément magnétorésistif sont tous les deux orientés sensiblement parallèlement à la direction XY. Le deuxième élément magnétorésistif est simplement translaté par rapport au premier élément magnétorésistif 11_MR. La direction d'aimantation fixe de la couche de référence du premier élément magnétorésistif et la direction d'aimantation fixe de la couche de référence du deuxième élément magnétorésistif peuvent ainsi avantageusement être définie lors d'une unique et même étape technologique.

Outre les caractéristiques qui viennent d'être évoquées dans le paragraphe précédent, le capteur de champ magnétique pour la détection d'au moins deux composantes de champ magnétique selon un aspect de l'invention peut présenter une ou plusieurs caractéristiques complémentaires parmi les suivantes, considérées individuellement ou selon toutes les combinaisons techniquement possibles :

- La deuxième direction Y est sensiblement perpendiculaire à la première direction X.

- Le premier élément magnétorésistif comporte une première couche antiferromagnétique pour le piégeage de la direction d'aimantation fixe de la couche de référence du premier élément magnétorésistif ; le deuxième élément magnétorésistif comporte une deuxième couche antiferromagnétique pour le piégeage de la direction d'aimantation fixe de la couche de référence du deuxième élément magnétorésistif ; et la première couche antiferromagnétique et la deuxième couche antiferromagnétique ont une même température de blocage.

- Le premier capteur comporte un premier aimant permanent et un deuxième aimant permanent agencés de part et d'autre du premier élément magnétorésistif, lesdits premier et deuxième aimants permanents ayant une même direction d'aimantation polarisant l'aimantation de la couche sensible du premier élément magnétorésistif et déterminant la première direction d'aimantation de ladite couche sensible lorsque le premier élément magnétorésistif est au repos, et le deuxième capteur comporte un premier aimant permanent et un deuxième aimant permanent agencés de part et d'autre du deuxième élément magnétorésistif, lesdits premier et deuxième aimants permanents ayant une même direction d'aimantation polarisant l'aimantation de la couche sensible du deuxième élément magnétorésistif et déterminant la première direction d'aimantation de ladite couche sensible lorsque le deuxième élément magnétorésistif est au repos, la direction d'aimantation des premier et deuxième aimants permanents du premier capteur étant sensiblement identique à la direction d'aimantation des premier et deuxième aimants permanents du deuxième capteur.

  Outre la définition de la direction d'aimantation fixe de la couche de référence du premier élément magnétorésistif et de la direction d'aimantation fixe de la couche de référence du deuxième élément magnétorésistif lors d'une unique et même étape technologique, l''invention permet alors avantageusement de définir les polarisations des directions d'aimantation des couches douces en une seule et même deuxième étape technologique.

- Chacun des premier et deuxième concentrateurs de flux présente une première dimension, dite « grande dimension », et une deuxième dimension, dite « petite dimension », inférieure à la première dimension ; la grande dimension du premier concentrateur de flux est suivant la première direction X et la petite dimension du premier concentrateur de flux est suivant la deuxième direction Y ; la grande dimension du deuxième concentrateur de flux est suivant la deuxième direction Y et la petite dimension du deuxième concentrateur de flux est suivant la première direction X.

- Les premier et deuxième capteurs ont leur élément magnétorésistif constitué des mêmes matériaux.

- Chaque pièce magnétique de chaque concentrateur de flux présente un côté chanfreiné.

- Le côté chanfreiné de chaque pièce magnétique de chaque concentrateur de flux est un côté biseauté.

- Chaque pièce magnétique de chaque concentrateur de flux présente le côté chanfreiné et un deuxième côté chanfreiné.

- Le deuxième côté chanfreiné est un deuxième côté biseauté.

Un autre aspect de l'invention concerne un capteur de champ magnétique pour la détection d'au moins trois composantes de champ magnétique comportant :

- le capteur de champ magnétique pour la détection d'au moins deux composantes de champ magnétique selon un aspect de l'invention, et
- un troisième capteur pour la détection d'une troisième composante magnétique suivant une troisième direction Z distincte de la première direction X et de la deuxième direction Y comprenant :

  ○ un troisième concentrateur de flux comportant une première pièce magnétique, une deuxième pièce magnétique et un entrefer entre les premières et deuxième pièces magnétiques ;
  ○ un troisième élément magnétorésistif agencé dans l'entrefer du troisième concentrateur de flux ;

le troisième concentrateur de flux présentant une première dimension dite « grande dimension » suivant une direction sensiblement parallèle à la troisième direction Z, et une deuxième dimension dite « petite dimension » suivant une direction sensiblement parallèle à la direction XY des premier et deuxième capteurs

Avantageusement, les éléments magnétorésistifs des premier, deuxième et troisième capteurs sont constitués des mêmes matériaux avec des directions de leur couche de référence et de leur couche sensible au repos sensiblement identiques.

L'invention concerne également un procédé de fabrication d'un capteur de champ magnétique pour la détection d'au moins trois composantes de champ magnétique selon un aspect de l'invention comportant les étapes suivantes :

- une étape de réalisation du premier capteur sur une face d'une première région d'un substrat, de réalisation du deuxième capteur sur une face d'une deuxième région du substrat et de réalisation du troisième capteur sur une face d'une troisième région du substrat, ledit substrat s'étendant suivant un plan de référence OXY, la première direction X et la deuxième direction Y étant parallèles au plan de référence OXY ;
- une étape selon laquelle une première partie de la troisième région du substrat est séparée du reste du substrat, la première partie comportant la face sur laquelle le troisième capteur est réalisé et la première partie faisant saillie du plan de référence OXY.

Outre les caractéristiques qui viennent d'être évoquées dans le paragraphe précédent, le procédé de fabrication d'un capteur de champ magnétique pour la détection d'au moins trois composantes de champ magnétique selon un aspect de l'invention peut présenter une ou plusieurs caractéristiques complémentaires parmi les suivantes, considérées individuellement ou selon toutes les combinaisons techniquement possibles :

- La première partie de la troisième région du substrat qui fait saillie du plan de référence OXY s'étend sensiblement suivant un plan perpendiculaire au plan de référence OXY.

- La première partie de la troisième région du substrat est séparée du reste du substrat par une étape de gravure d'une deuxième partie et d'une troisième partie de la troisième région du substrat.

L'invention concerne également un procédé d'écriture de la direction d'aimantation des couches de référence dans un capteur de champ magnétique pour la détection d'au moins deux composantes de champ magnétique ou dans un capteur de champ magnétique pour la détection d'au moins trois composantes de champ magnétique, dans lequel la direction d'aimantation fixe de la couche de référence de chaque élément magnétorésistif est piégée par une couche antiferromagnétique, chaque couche antiferromagnétique de piégeage ayant une même température de blocage, le procédé comportant les étapes suivantes :

- chauffage simultané des couches antiferromagnétiques de piégeage à une température supérieure à la température de blocage ;
- lorsque les couches antiferromagnétiques de piégeage ont une température supérieure à la température de blocage, application simultanée aux couches antiferromagnétiques de piégeage d'un champ d'écriture orienté suivant une direction souhaitée pour l'aimantation des couches de référence ;
- arrêt du chauffage tout en maintenant l'application du champ d'écriture aux couches antiferromagnétiques de piégeage ;
- lorsque les couches antiferromagnétiques de piégeage ont retrouvé une température inférieure à la température de blocage, arrêt de l'application du champ d'écriture.

L'invention et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif de l'invention.

- La figure 1 montre une représentation schématique d'un capteur uniaxial selon l'état de la technique.
- La figure 2 montre une représentation schématique d'un capteur de champ magnétique pour la détection d'au moins deux composantes de champ magnétique selon l'état de la technique.
- La figure 3a montre une représentation schématique d'un capteur de champ magnétique pour la détection d'au moins deux composantes de champ magnétique selon un aspect de l'invention, dans un premier état dit « de repos ».
- La figure 3b montre une représentation schématique du capteur de champ magnétique pour la détection d'au moins deux composantes de champ magnétique de la figure 3a, dans un deuxième état dit « excité ».
- La figure 4a montre schématiquement une première configuration d'un concentrateur de flux d'un capteur pour la détection d'une composante de champ magnétique suivant une première direction.
- La figure 4b montre schématiquement une deuxième configuration alternative d'un concentrateur de flux d'un capteur pour la détection d'une composante de champ magnétique suivant la première direction.
- La figure 4c montre schématiquement une troisième configuration alternative d'un concentrateur de flux d'un capteur pour la détection d'une composante de champ magnétique suivant la première direction.
- La figure 5a montre le résultat d'une première simulation selon laquelle un champ magnétique à mesurer orienté selon la première direction est appliqué au concentrateur de flux d'un capteur destiné à détecter une composante de champ magnétique suivant la première direction.
- La figure 5b montre le résultat d'une deuxième simulation selon laquelle un champ magnétique à mesurer orienté selon une deuxième direction est appliqué au concentrateur de flux du capteur de la figure 5a, destiné à détecter une composante de champ magnétique suivant la première direction.
- La figure 6a montre schématiquement une deuxième géométrie possible pour chaque pièce magnétique de chaque concentrateur de flux.
- La figure 6b montre schématiquement une troisième géométrie possible pour chaque pièce magnétique de chaque concentrateur de flux.
- La figure 6c montre schématiquement une quatrième géométrie possible pour chaque pièce magnétique de chaque concentrateur de flux.
- La figure 6d montre schématiquement une cinquième géométrie possible pour chaque pièce magnétique de chaque concentrateur de flux.
- La figure 7 montre schématiquement l'évolution d'une tension aux bornes d'un élément magnétorésistif en fonction d'un champ appliqué à l'élément magnétorésistif et que l'on souhaite mesurer.
- La figure 8 montre schématiquement un capteur de champ magnétique pour la détection d'au moins trois composantes de champ magnétique selon un autre aspect de l'invention, à l'issue d'une première étape de fabrication.
- La figure 9 montre schématiquement le capteur de champ magnétique pour la détection d'au moins trois composantes de champ magnétique selon un autre aspect de l'invention, à l'issue d'une deuxième étape de fabrication.

- La figure 10 montre schématiquement un exemple de réalisation de la deuxième étape de fabrication.

## DESCRIPTION DETAILLEE D'AU MOINS UN MODE DE REALISATION DE L'INVENTION

Sauf précision contraire, un même élément apparaissant sur des figures différentes présente une référence unique.

Les figures 1 et 2 ont été précédemment décrites.

On notera que dans la description qui suit, l'entrefer du premier concentrateur de flux et l'entrefer du deuxième concentrateur de flux sont orientés parallèlement à une direction XY qui la bissectrice de la première direction X et de la deuxième direction Y étant entendu que l'invention s'applique également à directions s'écartant de $\pm 15°$ de la bissectrice. Au-delà, la dissymétrie des mesures sera trop préjudiciable à la sensibilité du dispositif.

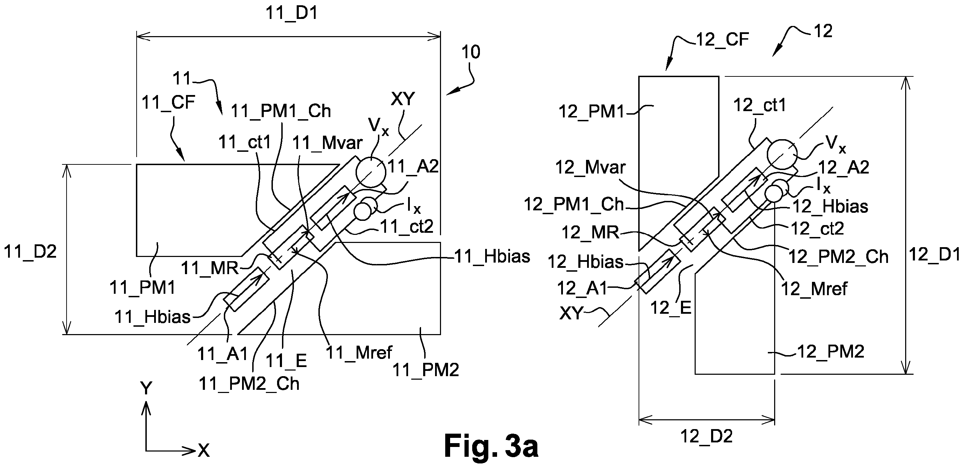

La figure 3a montre une représentation schématique d'un capteur de champ magnétique 10 pour la détection d'au moins deux composantes de champ magnétique selon un premier mode de réalisation de l'invention, dans un premier état dit « de repos ». Dans l'état de repos, aucun champ magnétique à mesurer n'est appliqué au capteur de champ magnétique 10.

Le capteur de champ magnétique 10 comporte :

- un premier capteur 11 pour la détection d'une première composante de champ magnétique suivant un premier axe X ;
- un deuxième capteur 12 pour la détection d'une deuxième composante de champ magnétique suivant un deuxième axe Y.

Les premier et deuxième capteurs 11 et 12 sont typiquement des capteurs GMR à magnétorésistance géante, également appelés « vannes de spin ». Une vanne de spin présente typiquement une magnétorésistance de l'ordre de 5 à 20 %. Alternativement, les premier et deuxième capteurs 11 et 12 peuvent être des capteurs TMR à jonction tunnel magnétique, préférentiellement à base de MgO pour la barrière tunnel. Une jonction tunnel magnétique présente typiquement une magnétorésistance plus importante qu'une vanne de spin, de l'ordre de 100 à 250 %. Selon une autre alternative, les premier et deuxième capteurs 11 et 12 peuvent être des capteurs AMR à anisotropie de magnétorésistance. La sensibilité des capteurs AMR est moindre par rapport à celle des capteurs GMR ou TMR.

Le premier axe X est distinct du deuxième axe Y. Le premier axe X est préférentiellement sensiblement perpendiculaire au deuxième axe Y. On entend par « sensiblement perpendiculaire » le fait que le premier axe X forme avec le deuxième axe Y un angle compris entre 85° et 95°, et préférentiellement égal à 90°. Le premier axe X et le deuxième axe Y définissent un plan de référence. Le premier capteur 11 et le deuxième capteur 12 sont typiquement agencés à la surface d'un substrat s'étendant suivant le plan de référence.

Le premier capteur 11 comporte :

- un premier concentrateur de flux 11_CF, comprenant une première pièce magnétique 11_PM1, une deuxième pièce magnétique 11_PM2 et un entrefer 11_E entre les première et deuxième pièces magnétiques ;
- un premier élément magnétorésistif 11_MR agencé dans l'entrefer 11_E du premier concentrateur de flux 11_CF ;
- un premier contact électrique 11_ct1 et un deuxième contact électrique 11_ct2 ;
- avantageusement, un premier aimant permanent 11_A1 et un deuxième aimant permanent 11_A2 agencés de part et d'autre du premier élément magnétorésistif 11_MR.

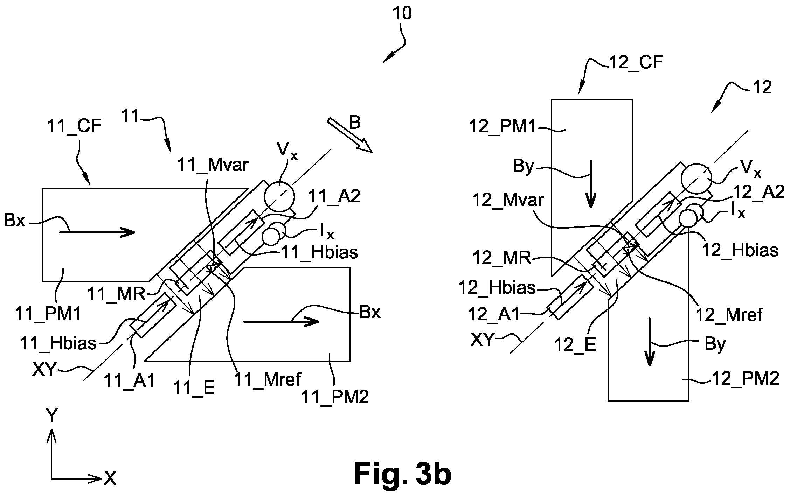

Lorsque le premier capteur 11 est un capteur GMR, c'est-à-dire lorsque le premier élément magnétorésistif 11_MR est une vanne de spin, les premier et deuxième contacts électriques 11_ct1 et 11_ct2 sont pris aux deux extrémités latérales de la vanne de spin, ainsi que le montrent les figures 3a et 3b. Selon une alternative non représentée, le premier capteur 11 peut également comporter des troisième et quatrième contacts électriques, ce qui permet avantageusement de s'affranchir des résistances de contact. Selon une alternative non représentée, lorsque le premier capteur 11 est un capteur TMR, c'est-à-dire lorsque le premier élément magnétorésistif 11_MR est une jonction tunnel magnétique, les premier et deuxième contacts 11_ct1 et 11_ct2 sont pris l'un sous l'empilement et l'autre sur l'empilement de manière qu'un courant puisse traverser perpendiculairement la barrière tunnel.

Le deuxième capteur 12 comporte :

- un deuxième concentrateur de flux 12_CF, comprenant une première pièce magnétique 12_PM1, une deuxième pièce magnétique 12_PM2 et un entrefer 12_E entre les première et deuxième pièces magnétiques ;
- un deuxième élément magnétorésistif 12_MR agencé dans l'entrefer 12_E du deuxième concentrateur de flux 12_CF ;
- un premier contact électrique 12_ct1 et un deuxième contact électrique 12_cet2 ;

- avantageusement, un premier aimant permanent 12_A1 et un deuxième aimant permanent 12_A2 agencés de part et d'autre du deuxième élément magnétorésistif 12_MR.

Lorsque le deuxième capteur 12 est un capteur GMR, c'est-à-dire lorsque le deuxième élément magnétorésistif 12_MR est une vanne de spin, les premier et deuxième contacts électriques 12_ct1 et 12_ct2 sont pris aux deux extrémités latérales de la vanne de spin, ainsi que le montrent les figures 3a et 3b. Selon une alternative non représentée, le deuxième capteur 12 peut également comporter des troisième et quatrième contacts électriques, ce qui permet avantageusement de s'affranchir des résistances de contact. Selon une alternative non représentée, lorsque le deuxième capteur 12 est un capteur TMR, c'est-à-dire lorsque le deuxième élément magnétorésistif 12_MR est une jonction tunnel magnétique, les premier et deuxième contacts 12_ct1 et 12_ct2 sont pris l'un sous l'empilement et l'autre sur l'empilement de manière qu'un courant puisse traverser perpendiculairement la barrière tunnel.

Le premier concentrateur de flux 11_CF présente une première dimension 11_D1, dite « grande dimension », et une deuxième dimension 11_D2, dite « petite dimension ». La grande dimension 11_D1 du premier concentrateur de flux est suivant le premier axe X. La petite dimension 11_D2 du premier concentrateur de flux est suivant le deuxième axe Y. Afin de créer une dissymétrie pour différencier les mesures selon les deux directions X et Y, il faut que la petite dimension 11_D2 soit plus grande que la grande dimension 11_D1 (il en va de même de la petite dimension 12_D2 et de la grande dimension 12_D1). Un facteur 1.5 est suffisant pour obtenir cette différenciation. Donc, la grande dimension 11_D1 et la petite dimension 11_D2 du premier concentrateur de flux sont préférentiellement telles que :

$$1,5 \times 11\_D2 \leq 11\_D1$$

Le deuxième concentrateur de flux 12_CF présente également une première dimension 12_D1, dite « grande dimension », et une deuxième dimension 12_D2, dite « petite dimension ». Cette fois, la grande dimension 12_D1 du deuxième concentrateur de flux est suivant le deuxième axe Y. La petite dimension 12_D2 du deuxième concentrateur de flux est suivant le premier axe Y. La grande dimension 12_D1 et la petite dimension 12_D2 du deuxième concentrateur de flux sont préférentiellement telles que :

$$1,5 \times 12\_D2 \leq 12\_D1$$

Par ailleurs, les concentrateurs sont les plus longs possible car plus la grande dimension est importante plus la composante magnétique orientée suivant la direction de la grande dimension est amplifiée dans l'entrefer du concentrateur de flux, jusqu'à atteindre une valeur maximale de façon asymptotique. De façon avantageuse, $11\_D1 \geq 10 \times 11\_D2$ et préférentiellement $11\_D1 \geq 30 \times 11\_D2$. De même, de façon avantageuse, $12\_D1 \geq 10 \times 12\_D2$ et préférentiellement $12\_D1 \geq 30 \times 12\_D2$.

Les premier et deuxième concentrateurs de flux 11_CF et 12_CF sont typiquement réalisés en un matériau doux ayant une susceptibilité linéaire, tel que par exemple du Permalloy $Ni_{80}Fe_{20}$, du Supermalloy $Ni_{75}Fe_{20}Mo_5$ ou un alliage $Co_{90}Fe_{10}$.

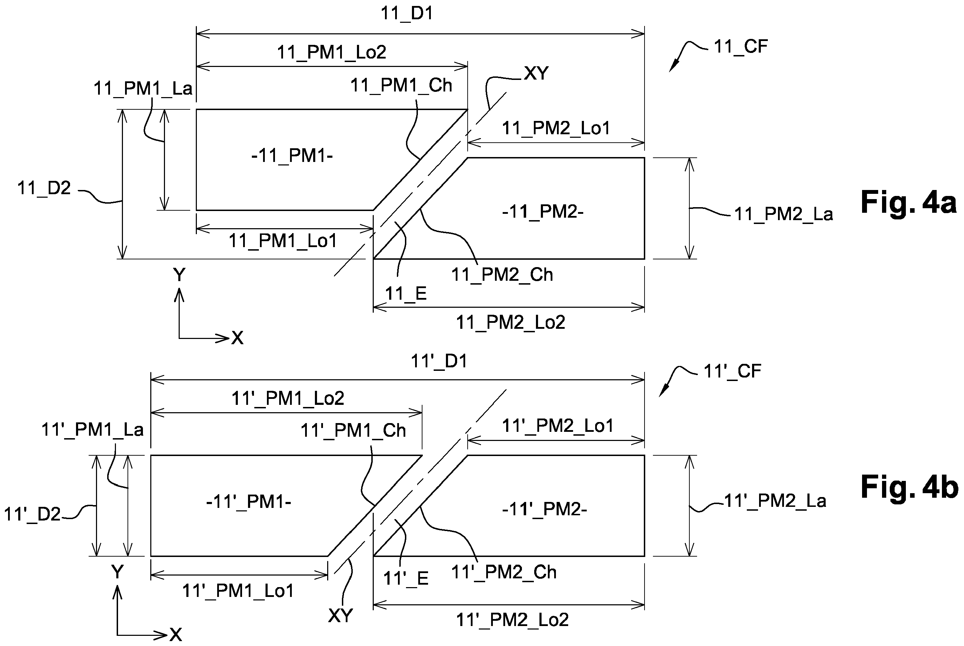

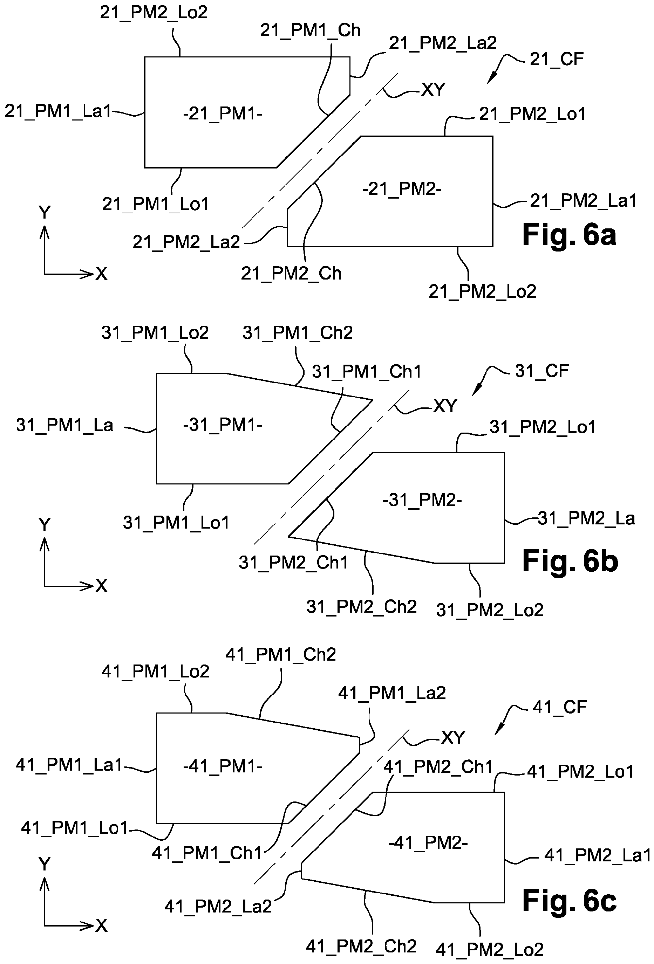

Un exemple de dimensionnement pour les premier et deuxième concentrateurs de flux 11_CF et 12_CF est ultérieurement décrit, en référence à la figure 4a. Plusieurs exemples de géométries alternatives pour les premier et deuxième concentrateurs de flux 11_CF et 12_CF sont ultérieurement décrits, en référence aux figures 6a à 6d.

L'entrefer 11_E du premier concentrateur de flux est orienté sensiblement parallèlement à une direction XY qui est la bissectrice du premier axe X et du deuxième axe Y. Pour obtenir une telle orientation pour l'entrefer 11_E du premier concentrateur de flux, la première pièce magnétique 11_PM1 du premier concentrateur de flux présente un côté 11_PM1_Ch biseauté suivant la direction XY, et la deuxième pièce magnétique 11_PM2 du premier concentrateur de flux présente un côté 12_PM2_Ch biseauté suivant la direction XY.

De manière analogue, l'entrefer 12_E du deuxième concentrateur de flux est orienté sensiblement parallèlement à la direction XY. Pour obtenir une telle orientation pour l'entrefer 12_E du deuxième concentrateur de flux, la première pièce magnétique 12_PM1 du deuxième concentrateur de flux présente un côté 12_PM1_Ch biseauté suivant la direction XY, et la deuxième pièce magnétique 12_PM2 du deuxième concentrateur de flux présente un côté 12_PM2_Ch biseauté suivant la direction XY.

Dans le premier état de repos, le champ créé par le premier concentrateur de flux 11_CF dans son entrefer 11_E est négligeable, et le champ créé par le deuxième concentrateur de flux 12_CF dans son entrefer 12_E est négligeable.

Le premier élément magnétorésistif 11_MR comporte :

- une couche de référence, également appelée « couche piégée », ayant une direction d'aimantation fixe 11_Mref, et
- une couche sensible, également appelée « couche douce », ayant une direction d'aimantation variable 11_Mvar.

De manière analogue, le deuxième élément magnétorésistif 12_MR comporte :

- une couche de référence, également appelée « couche piégée », ayant une direction d'aimantation fixe 12_Mref, et
- une couche sensible, également appelée « couche douce », ayant une direction d'aimantation variable 12_Mvar.

Le piégeage de la couche de référence du premier élément magnétorésistif 11_MR est en général réalisé par interaction avec une couche antiferromagnétique adjacente à ladite couche de référence, par un mécanisme d'anisotropie d'échange. De même, le piégeage de la couche de référence du deuxième élément magnétorésistif 12_MR est en général réalisé par un mécanisme d'anisotropie d'échange, par interaction avec une couche antiferromagnétique adjacente à ladite couche de référence. Alternativement, la couche de référence du premier élément magnétorésistif 11_MR peut être une couche antiferromagnétique synthétique comportant deux couches ferromagnétiques couplées antiparallèlement à travers une fine couche de couplage antiparallèle. Cette couche antiferromagnétique synthétique peut elle-même être piégée par interaction avec une autre couche antiferromagnétique. De même, la couche de référence du deuxième élément magnétorésistif 12_MR peut alternativement être une couche antiferromagnétique synthétique telle que précédemment décrite. Le matériau antiferromagnétique de la couche antiferromagnétique du premier élément magnétorésistif 11_MR est avantageusement identique au matériau antiferromagnétique de la couche antiferromagnétique du deuxième élément magnétorésistif 12_MR. On permet ainsi la fabrication simultanée des premier et deuxième éléments magnétorésistifs. La direction d'aimantation fixe 11_Mref de la couche de référence du premier élément magnétorésistif est sensiblement identique à la direction d'aimantation fixe 12_Mref de la couche de référence du deuxième élément magnétorésistif.

Ainsi, la direction d'aimantation fixe 11_Mref de la couche de référence du premier élément magnétorésistif et la direction d'aimantation fixe 12_Mref de la couche de référence du deuxième élément magnétorésistif sont avantageusement définies et obtenues lors d'une seule et même étape technologique. Dans le cas où les premier et deuxième capteurs 11 et 12 sont des capteurs à magnétorésistance géante GMR, également appelés « vannes de spin », cette étape technologique unique est typiquement la suivante :

- la couche antiferromagnétique du premier capteur 11 et la couche antiferromagnétique du deuxième capteur 12, qui sont avantageusement réalisées dans le même matériau antiferromagnétique et ont donc la même température de blocage, sont chauffées à une température excédant la température de blocage. Lorsque la température de la couche antiferromagnétique du premier capteur 11 dépasse la température de blocage, la direction d'aimantation 11_Mref de la couche de référence du premier capteur n'est plus piégée par ladite couche antiferromagnétique et peut alors être modifiée. De même, lorsque la température de la couche antiferromagnétique du deuxième capteur 12 dépasse la température de blocage, la direction d'aimantation 12_Mref de la couche de référence du deuxième capteur peut être modifiée.
- Tout en maintenant une température excédant la température de blocage, la direction d'aimantation 11_Mref de la couche de référence du premier capteur et la direction d'aimantation 12_Mref de la couche de référence du deuxième capteur sont alors définies simultanément par l'application d'un champ orienté dans la direction souhaitée.
- Enfin, le chauffage est arrêté : la couche antiferromagnétique du premier capteur 11 et la couche antiferromagnétique du deuxième capteur 12 retrouvent une température inférieure à leur température de blocage. L'application du champ orienté dans la direction souhaitée est maintenue jusqu'à ce que la couche antiferromagnétique du premier capteur 11 et la couche antiferromagnétique du deuxième capteur 12 aient à nouveau une température inférieure à leur température de blocage. La direction d'aimantation 11_Mref de la couche de référence du premier capteur et la direction d'aimantation 12_Mref de la couche de référence du deuxième capteur sont alors piégées dans la direction précédemment définie.

Dans l'exemple représenté à la figure 3a, la direction d'aimantation fixe 11_Mref de la couche de référence du premier élément magnétorésistif et la direction d'aimantation fixe 12_Mref de la couche de référence du deuxième élément magnétorésistif sont toutes les deux définies sensiblement perpendiculairement à la direction XY.

La direction d'aimantation variable 11_Mvar de la couche sensible du premier élément magnétorésistif est avantageusement polarisée transversalement par rapport à la direction d'aimantation fixe 11_Mref de la couche de référence du premier élément magnétorésistif, grâce au premier aimant permanent 11_A1 et au deuxième aimant permanent 11_A2 agencés de part et d'autre du premier élément magnétorésistif 11_MR. Les premier et deuxième aimants permanents 11_A1 et 11_A2 du premier capteur 11 ont une même direction d'aimantation 11_Hbias, qui définit la polarisation de la direction d'aimantation variable 11_Mvar de la couche sensible du premier élément magnétorésistif. Lorsqu'aucun champ magnétique à mesurer n'est appliqué au premier capteur 11, c'est-à-dire lorsque le premier capteur 11 est dans un état de repos, la direction d'aimantation variable 11_Mvar du premier élément magnétorésistif est suivant la direction d'aimantation 11_Hbias des premier et deuxième aimants permanents 11_A1 et 11_A2 du premier capteur 11.

De manière analogue, la direction d'aimantation variable 12_Mvar de la couche sensible du deuxième élément magnétorésistif est avantageusement polarisée transversalement par rapport à la direction d'aimantation fixe 12_Mref de la couche de référence du deuxième élément magnétorésistif, grâce au premier aimant permanent 12_A1 et au deuxième aimant permanent 12_A2 agencés de part et d'autre du premier élément magnétorésistif 12_MR. Les premier et deuxième aimants permanents 12_A1 et 12_A2 du deuxième capteur 12 ont une même direction d'aimantation 12_Hbias, qui définit la polarisation de la direction d'aimantation variable 12_Mvar de la couche sensible du deuxième élément magnétorésistif. Lorsqu'aucun champ magnétique à mesurer n'est appliqué au deuxième capteur 12, c'est-à-dire lorsque le deuxième capteur 12 est dans un état de repos, la direction d'aimantation variable 12_Mvar du deuxième élément magnétorésistif est suivant la direction d'aimantation 12_Hbias des premier et deuxième aimants permanents 12_A1 et 12_A2 du deuxième capteur 12.

Les premier et deuxième aimants permanents 11_A1 et 11_A2 du premier capteur 11 sont avantageusement réalisés dans un matériau identique au matériau des premier et deuxième aimants permanents 12_A1 et 12_A2 du deuxième capteur 12. On permet ainsi leur fabrication simultanée. Chaque aimant permanent est typiquement réalisé en un matériau dur, tel qu'un alliage à base de Co et de Cr, ou de Sm et de Co, ou de NdFeB en couches minces.

La direction d'aimantation 11_Hbias des premier et deuxième aimants permanents 11_A1 et 11_A2 du premier capteur 11 est avantageusement identique à la direction d'aimantation 12_Hbias des premier et deuxième aimants permanents 12_A1 et 12_A2 du deuxième capteur 12. Ainsi, la direction d'aimantation 11_Hbias des premier et deuxième aimants permanents 11_A1 et 11_A2 du premier capteur 11 et la direction d'aimantation 12_Hbias des premier et deuxième aimants permanents 12_A1 et 12_A2 du deuxième capteur 12 sont avantageusement définies et obtenues lors d'une seule et même étape technologique. Cette étape technologique unique consiste typiquement en l'application d'un fort champ magnétique, supérieur au champ coercitif du matériau des aimants permanents, orienté dans la direction souhaitée. L'application de ce fort champ magnétique induit dans chaque aimant permanent une aimantation rémanente dans la direction désirée.

Dans l'exemple représenté à la figure 3a, la direction d'aimantation 11_Hbias des aimants permanents du premier capteur 11 et la direction d'aimantation 12_Hbias des aimants permanents du deuxième capteur 12 sont toutes les deux définies sensiblement parallèlement à la direction XY.

La figure 3b montre une représentation schématique du capteur de champ magnétique 10 pour la détection d'au moins deux composantes de champ magnétique selon le premier mode de réalisation de l'invention, dans un deuxième état dit « excité ». Dans l'état excité, un champ magnétique B à mesurer est appliqué au capteur de champ magnétique 10, et donc au premier capteur 11 et au deuxième capteur 12. Le champ magnétique B à mesurer présente une première composante Bx suivant l'axe X, et une deuxième composante By selon l'axe Y. Le premier capteur 11 est sensible à la première composante Bx tandis que le deuxième capteur 12 est sensible à la deuxième composante By. Sous l'effet du champ magnétique B à mesurer, le premier concentrateur de flux 11_CF rayonne un premier champ magnétique au niveau de son entrefer 11_E et le deuxième concentrateur de flux 12_CF rayonne un deuxième champ magnétique au niveau de son entrefer 12_E. Le premier champ magnétique est orienté dans une direction sensiblement perpendiculaire à la direction d'aimantation 11_Hbias des aimants permanents du premier capteur 11. Le deuxième champ magnétique est orienté dans une direction sensiblement perpendiculaire à la direction d'aimantation 12_Hbias des aimants permanents du premier capteur 12. Les premier et deuxième champs magnétiques sont donc avantageusement orientés selon une même direction. Dans l'exemple représenté à la figure 3b, les premier et deuxième champs magnétiques sont ainsi orientés sensiblement perpendiculairement à la direction XY.

La direction d'aimantation 11_Mvar de la couche douce du premier élément magnétorésistif 11_MR varie sous l'effet du premier champ magnétique, qui est rayonné dans l'entrefer 11_E du premier concentrateur de flux suivant une direction différente de la direction de polarisation de la couche douce du premier élément magnétorésistif 11_MR. De même, la direction d'aimantation 12_Mvar de la couche douce du deuxième élément magnétorésistif 12_MR varie sous l'effet du deuxième champ magnétique, qui est rayonné dans l'entrefer 12_E du deuxième concentrateur de flux suivant une direction différente de la direction de polarisation de la couche douce du deuxième élément magnétorésistif 12_MR.

Le premier élément magnétorésistif 11_MR et le deuxième élément magnétorésistif 12_MR sont du même type, c'est-à-dire par exemple qu'ils sont tous les deux des vannes de spin, ou tous les deux des jonctions tunnels magnétiques, ou tous les deux des éléments à anisotropie de magnétorésistance. Le premier élément magnétorésistif 11_MR et le deuxième élément magnétorésistif 12_MR sont en outre avantageusement réalisés à partir des mêmes matériaux. Comme illustré aux figures 3a et 3b, le premier élément magnétorésistif 11_MR et le deuxième élément magnétorésistif 12_MR présentent la même orientation spatiale dans le plan défini par les axes X et Y : le premier élément magnétorésistif 11_MR et le deuxième élément magnétorésistif 12_MR sont tous les deux orientés sensiblement parallèlement à la direction XY. Le deuxième élément magnétorésistif 12_MR est simplement translaté par rapport au premier élément magnétorésistif 11_MR. En revanche, le premier concentrateur de flux 11_CF et le deuxième concentrateur de flux 12_CF ne présentent pas la même orientation spatiale dans le plan défini par les axes X et Y : le premier concentrateur de flux 11_CF a sa grande dimension 11_D1 suivant l'axe X et le deuxième concentrateur de flux 12_CF a sa grande dimension 12_D1 suivant l'axe Y. La géométrie et l'orientation de chaque concentrateur de flux contribuent à déterminer l'axe de sensibilité de chaque capteur uniaxial.

La figure 4a montre schématiquement le premier concentrateur de flux 11_CF du premier capteur 11. On rappelle que le premier capteur 11 est destiné à détecter une composante de champ magnétique suivant l'axe X. La grande dimension 11_D1 du premier concentrateur de flux 11_CF est ainsi suivant l'axe X, tandis que la petite dimension 11_D2 du premier concentrateur de flux est suivant l'axe Y. L'entrefer 11_E du premier concentrateur de flux est orienté sensiblement à 45° de la grande dimension 11_D1 du premier concentrateur de flux, c'est-à-dire sensiblement suivant la direction XY.

La première pièce magnétique 11_PM1 du premier concentrateur de flux présente :

- un premier côté ou petit côté 11_PM1_Lo1 suivant l'axe X ;
- un deuxième côté ou grand côté 11_PM1_Lo2 suivant l'axe X ;
- un côté 11_PM1_La suivant l'axe Y ;
- le côté 11_PM1_Ch biseauté suivant la direction XY ;
- une épaisseur, non représentée à la figure 4a, suivant une direction Z perpendiculaire au plan OXY défini par les axes X et Y.

La deuxième pièce magnétique 11_PM2 du premier concentrateur de flux présente :

- un premier côté ou petit côté 11_PM2_Lo1 suivant l'axe X ;
- un deuxième côté ou grand côté 11_PM2_Lo2 suivant l'axe X ;
- un côté 11_PM2_La suivant l'axe Y ;
- le côté 11_PM2_Ch biseauté suivant la direction XY ;
- une épaisseur, non représentée à la figure 4a, suivant la direction Z.

Dans l'exemple représenté à la figure 4a, le dimensionnement de la première pièce magnétique 11_PM1 du premier concentrateur de flux est le suivant :

- le petit côté 11_PM1_Lo1 suivant l'axe X mesure 400 nm ;
- le grand côté 11_PM1_Lo2 suivant l'axe X mesure 600 nm ;
- le côté 11_PM1 suivant l'axe Y mesure 200 nm
- l'épaisseur est de 40 nm.

De même, le dimensionnement de la deuxième pièce magnétique 11_PM2 du premier concentrateur de flux est le suivant :

- le petit côté 11_PM2_Lo1 suivant l'axe X mesure 400 nm ;
- le grand côté 11_PM2_Lo2 suivant l'axe X mesure 600 nm ;
- le côté 11_PM2 suivant l'axe Y mesure 200 nm ;
- l'épaisseur est de 40 nm.

De manière analogue, la première pièce magnétique 12_PM1 du deuxième concentrateur de flux 12_CF présente typiquement :

- un premier côté ou petit côté suivant l'axe Y mesurant 400 nm ;
- un deuxième côté ou grand côté suivant l'axe Y mesurant 600 nm ;
- un côté suivant l'axe X mesurant 200 nm ;
- le côté biseauté 12_PM1_Ch suivant la direction XY
- une épaisseur de 40 nm suivant la direction Z.

La deuxième pièce magnétique 12_PM2 du deuxième concentrateur de flux 12_CF présente typiquement :

- un premier côté ou petit côté suivant l'axe Y mesurant 400 nm ;
- un deuxième côté ou grand côté suivant l'axe Y mesurant 600 nm ;
- un côté suivant l'axe X mesurant 200 nm ;
- le côté biseauté 12_PM2_Ch suivant la direction XY ;
- une épaisseur de 40 nm suivant la direction Z.

Une première configuration des première et deuxième pièces magnétiques de chaque concentrateur de flux est représentée à la figure 4a, ainsi qu'au figures 3a et 3b. Dans un concentrateur de flux selon la première configuration, la première pièce magnétique et la deuxième pièce magnétique sont désalignées, c'est-à-dire que le grand côté de la première pièce magnétique et le petit côté de la deuxième pièce magnétique ne sont pas alignés. La première pièce magnétique et la deuxième pièce magnétique sont translatées l'une par rapport à l'autre parallèlement à la direction XY, c'est-à-dire parallèlement à l'orientation de l'entrefer, de manière que la grande dimension du concentrateur de flux soit inférieure ou égale à la somme du grand côté de la première pièce magnétique et du petit côté de la deuxième pièce magnétique. Ainsi, dans l'exemple du premier capteur 11, le grand côté 11_PM1_Lo2 de la première pièce magnétique 11_PM1 et le petit côté 11_PM2_Lo1 de la deuxième pièce magnétique 11_PM2 ne sont pas alignés et présentent une ordonnée différente suivant l'axe Y. La grande dimension 11_D1 est égale à la somme du grand côté 11_PM1_Lo2 de la première pièce magnétique et du petit côté 11_PM2_Lo1 de la deuxième pièce magnétique. La petite dimension 11_D2 est supérieure à la largeur du côté 11_PM1_La de la première pièce magnétique 11_PM1, et la petite dimension est supérieure à la largeur du côté 11_PM2_La de la deuxième pièce magnétique 11_PM2.

La figure 4b montre schématiquement un concentrateur de flux alternatif 11'_CF ayant une deuxième configuration. Selon la deuxième configuration, la première pièce magnétique 11'_PM1 et la deuxième pièce magnétique 11'_PM2 du concentrateur de flux alternatif 11'_CF sont alignées: ainsi le grand côté 11'_PM1_Lo2 de la première pièce magnétique 11'_PM1 et le petit côté 11'_PM2_Lo1 de la deuxième pièce magnétique 11'_PM2 présentent la même ordonnée suivant l'axe Y, et de même le petit côté 11'_PM1_Lo1 de la première pièce magnétique 11'_PM1 et le grand côté 11'_PM2_Lo2 de la deuxième pièce magnétique présentent la même ordonnée suivant l'axe Y. Toujours selon la deuxième configuration, la grande dimension 11'_D1 est supérieure à la somme du grand côté 11'_PM1_Lo2 de la première pièce magnétique et du petit côté 11'_PM2_Lo1 de la deuxième pièce magnétique. La petite dimension 11'_D2 est égale à la largeur du côté 11'_PM1_La de la première pièce magnétique 11'_PM1 et à la largeur du côté 11'-PM2_La de la deuxième pièce magnétique 11'_PM2.

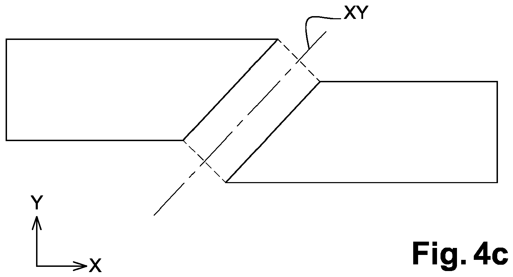

Grâce au désalignement, le flux magnétique tourne bien de 45° dans toute la largeur de l'entrefer jusque très près des bords. Sans le désalignement, le flux a tendance à ne plus tourner de 45° sur les bords de l'entrefer et plutôt à passer tout droit suivant la première direction. Ainsi, une solution avantageuse peut consister à une utiliser une configuration intermédiaire entre celle des figures 4a et 4b. Une telle configuration est illustrée à la figure 4c et correspond au cas où le coin supérieur droit de la pièce polaire de gauche et le coin supérieur gauche de la pièce polaire de droite sont sur une même droite perpendiculaire à la diagonale XY. Dans ce cas, l'entrefer a exactement la forme d'un rectangle de grande longueur parallèle à XY.

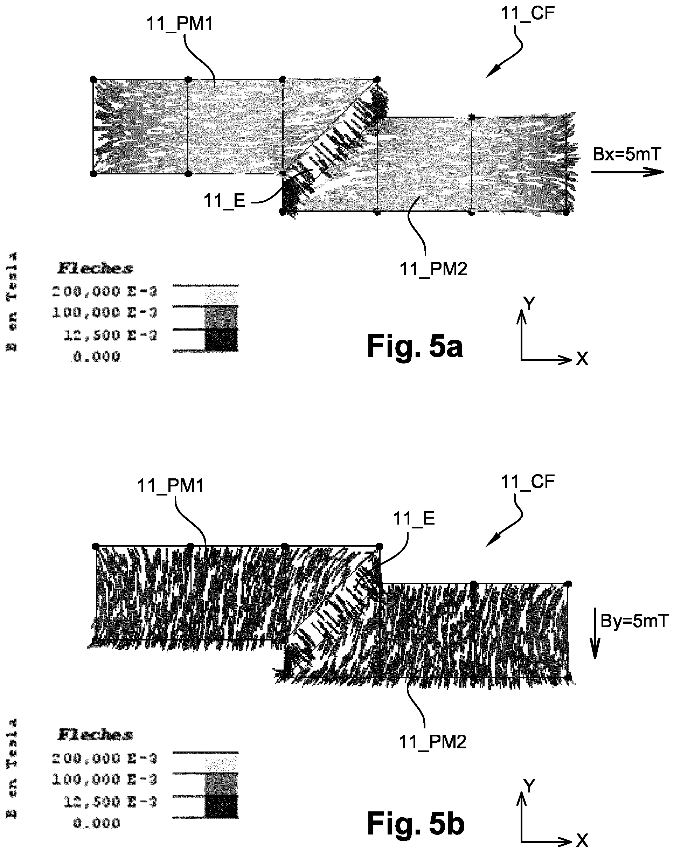

La figure 5a montre le résultat d'une première simulation selon laquelle un champ magnétique à mesurer orienté selon la direction X est appliqué au premier concentrateur de flux 11_CF du premier capteur 11 destiné à détecter une composante de champ magnétique suivant l'axe X. La figure 5b montre le résultat d'une deuxième simulation selon laquelle un champ magnétique à mesurer orienté selon la direction Y est appliqué au premier concentrateur de flux 11_CF du premier capteur 11 destiné à détecter une composante de champ magnétique suivant l'axe X.

La simulation est réalisée pour le cas où la première pièce magnétique 11_PM1 et la deuxième pièce magnétique 11_PM2 du premier concentrateur de flux sont réalisées en NiFe, de perméabilité isotrope X = 1000 et d'aimantation à saturation $\mu_o M_s$ = 1 Tesla. La simulation est réalisée pour le cas du dimensionnement qui a été précédemment décrit.

A la figure 5a, un champ magnétique Bx de 5 mT est appliqué au premier concentrateur de flux 11_CF. Le champ magnétique Bx est orienté suivant l'axe X, donc suivant la grande dimension 11_D1 du premier concentrateur de flux. Le résultat de la première simulation montre que le champ magnétique Bx de 5 mT appliqué au premier concentrateur de flux 11_CF entraîne la formation dans l'entrefer 11_E d'un champ orienté sensiblement suivant la direction XY avec un module de 32 mT.

A la figure 5b, un champ magnétique By de 5 mT est appliqué au premier concentrateur de flux 11_CF. Le champ magnétique By est orienté suivant l'axe Y, donc suivant la petite dimension 11_D2 du premier concentrateur de flux. Le résultat de la deuxième simulation montre que le champ magnétique By de 5 mT appliqué au premier concentrateur de flux 11_CF entraîne la formation dans l'entrefer 11_E d'un champ également orienté sensiblement suivant la direction XY, mais dont le module n'est cette fois que de 8 mT.

Les première et deuxième simulations montrent donc que :

- le champ qui se forme dans l'entrefer du premier concentrateur de flux 11_CF est fortement amplifié lorsque le champ appliqué au premier concentrateur de flux 11_CF est selon la grande dimension 11_D1 du concentrateur de flux ;
- le champ qui se forme dans l'entrefer du premier concentrateur de flux 11_CF est faiblement amplifié lorsque le champ appliqué au premier concentrateur de flux 11_CF est selon la petite dimension 11_D2 du concentrateur de flux.

Avantageusement, le champ magnétique à mesurer est inférieur au champ de saturation des première et deuxième pièces magnétiques de chaque concentrateur de flux, de manière que le champ qui se forme dans l'entrefer de chaque concentrateur de flux demeure dans un régime linéaire de variation en fonction du champ magnétique à mesurer. Dans l'exemple particulier de pièces magnétiques en NiFe, le régime linéaire est obtenu pour des champs faibles, typiquement inférieurs à 0,5 mT, ce qui est par exemple approprié pour que chaque concentrateur de flux soit sensible à une composante du champ terrestre, le champ terrestre étant de l'ordre de 0,05 mT.

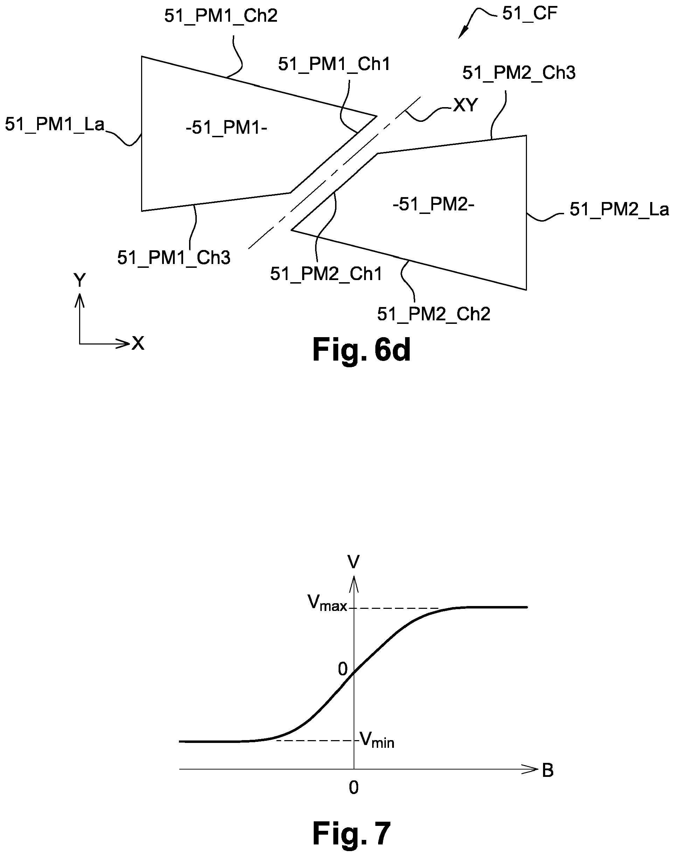

Lorsque le premier élément magnétorésistif 11_MR du premier capteur 11 est parcouru par un courant d'intensité I, il en résulte une tension à ses bornes qui varie en fonction du champ appliqué au premier élément magnétorésistif 11_MR, c'est-à-dire en fonction du champ formé dans l'entrefer 11_E du premier concentrateur de flux 11_CF. De même, lorsque le deuxième élément magnétorésistif 12_MR du deuxième capteur 12 est parcouru par un courant d'intensité I, il en résulte une tension à ses bornes qui varie en fonction du champ qui lui est appliqué, c'est-à-dire en fonction du champ formé dans l'entrefer 12_E du deuxième concentrateur de flux 12_CF. La figure 7 montre schématiquement l'évolution d'une tension V aux bornes d'un élément magnétorésistif en fonction d'un champ B appliqué à l'élément magnétorésistif et que l'on souhaite mesurer. Pour une certaine plage de champ autour du champ nul, la tension aux bornes de l'élément magnétorésistif varie linéairement en fonction du champ appliqué. En-dehors de cette plage linéaire, la tension aux bornes de l'élément magnétorésistif sature graduellement. Dans le cas préféré où l'élément magnétorésistif est une vanne de spin ou une jonction tunnel magnétique et où deux aimants permanents, agencés de part et d'autre de l'élément magnétorésistif, créent un champ de polarisation qui polarise la direction d'aimantation de la couche douce, la tension aux bornes de l'élément magnétorésistif sature graduellement pour des valeurs de champ de l'ordre de grandeur du champ de polarisation. L'intensité du champ de polarisation est alors avantageusement ajustée en fonction de la gamme de champ que l'on souhaite mesurer. On cherche généralement à travailler dans le régime linéaire de fonctionnement de l'élément magnétorésistif. Dans ce régime linéaire de fonctionnement, la tension V aux bornes de l'élément magnétorésistif varie linéairement en fonction du champ B agissant sur l'élément magnétorésistif :

$$V = \propto B$$

Le champ B agissant sur l'élément magnétorésistif est le champ dans l'entrefer du concentrateur de flux du capteur considéré. Le champ formé dans l'entrefer est amplifié différemment suivant les première et deuxième composantes du champ à mesurer. Lorsque l'on se trouve dans le régime de perméabilité linéaire du matériau des pièces magnétiques des concentrateurs de flux, on a :

$$B = a_x B_x + a_y B_y$$

où $a_x$ est le facteur d'amplification du concentrateur de flux considéré suivant la direction X, $B_x$ est la composante du champ appliqué suivant la direction X, ay est le facteur d'amplification du concentrateur de flux considéré suivant la direction Y et By est la composante du champ appliqué suivant la direction Y. Dans l'exemple représenté aux figures 3a et 3b, le premier concentrateur de flux 11_CF présente un fort facteur d'amplification suivant la direction X et un faible facteur d'amplification suivant la direction Y ; et au contraire le deuxième concentrateur de flux 12_CF présente un fort facteur d'amplification suivant la direction Y et un faible facteur d'amplification suivant la direction X.

Ainsi le premier élément magnétorésistif 11_MR délivre en régime linéaire une première tension de sortie V11 telle que :

$$V11 = \propto_{11} a_{11x} B_x + \propto_{11} a_{11y} B_y$$

où $\alpha_{11}$ est le coefficient linéaire du régime linéaire du premier élément magnétorésistif, $a_{11x}$ est le facteur d'amplification du premier concentrateur de flux 11_CF suivant la direction X et $a_{11y}$ est le facteur d'amplification du premier concentrateur de flux 11_CF suivant la direction Y.

De même, le deuxième élément magnétorésistif 12_MR délivre en régime linéaire une deuxième tension de sortie V12 telle que :

$$V12 = \propto_{12} a_{12x} B_x + \propto_{12} a_{12y} B_y$$

Où $\alpha_{12}$ est le coefficient linéaire du régime linéaire du deuxième élément magnétorésistif, $a_{12x}$ est le facteur d'amplification du deuxième concentrateur de flux 12_CF suivant la direction X et $a_{21y}$ est le facteur d'amplification du deuxième concentrateur de flux 12_CF suivant la direction Y.

Les deux équations précédentes peuvent s'écrire sous forme matricielle :

$$\begin{bmatrix} V11 \\ V12 \end{bmatrix} = M \begin{bmatrix} B_x \\ B_y \end{bmatrix}$$

avec :

$$M = \begin{bmatrix} \propto_{11} a_{11x} & \propto_{11} a_{11y} \\ \propto_{12} a_{12x} & \propto_{12} a_{12y} \end{bmatrix}$$

En inversant la matrice M, on peut donc remonter aux première et deuxième composantes du champ à partir des mesures de tension :

$$\begin{bmatrix} B_x \\ B_y \end{bmatrix} = M^{-1} \begin{bmatrix} V11 \\ V12 \end{bmatrix}$$

La matrice M est établie lors de la fabrication, par étalonnage du premier capteur 11 et du deuxième capteur 12 soumis successivement à un champ suivant X et à un champ suivant Y.

Les figures 3a, 3b, 4a et 4b ont montré une première géométrie pour chaque pièce magnétique de chaque concentrateur de flux, selon laquelle chaque pièce magnétique a une forme de biseau. Selon la première géométrie, chaque pièce magnétique comporte ainsi un côté biseauté. Différentes géométries alternatives pour chaque pièce magnétique de chaque concentrateur de flux sont à présent décrites aux figures 6a, 6b, 6c et 6d.

La figure 6a montre une deuxième géométrie possible pour chaque pièce magnétique de chaque concentrateur de flux. La figure 6a montre ainsi un concentrateur de flux 21_CF comportant une première pièce magnétique 21_PM1 et une deuxième pièce magnétique 21_PM2 ayant la deuxième géométrie. La première pièce magnétique 21_PM1 présente :

- un premier côté ou petit côté 21_PM1_Lo1 suivant l'axe X ;
- un deuxième côté ou grand côté 21_PM1_Lo2 suivant l'axe X ;
- un premier côté ou grand côté 21_PM1_La1 suivant l'axe Y ;
- un deuxième côté ou petit côté 21_PM1_La2 suivant l'axe Y ;
- un côté 21_PM1_Ch chanfreiné suivant la direction XY.

De manière analogue, la deuxième pièce magnétique 21_PM2 présente :

- un premier côté ou petit côté 21_PM2_Lo1 suivant l'axe X ;
- un deuxième côté ou grand côté 21_PM2_Lo2 suivant l'axe X ;
- un premier côté ou grand côté 21_PM2_La1 suivant l'axe Y ;
- un deuxième côté ou petit côté 21_PM2_La2 suivant l'axe Y ;
- un côté 21_PM2_Ch chanfreiné suivant la direction XY.

Dans la deuxième géométrie, la présence d'un côté chanfreiné au lieu d'un côté biseauté facilite avantageusement la réalisation de chaque pièce magnétique. En effet, le côté chanfreiné implique la présence d'un deuxième côté selon l'axe Y reliant le côté chanfreiné avec le deuxième côté selon l'axe X et donc la suppression d'un angle aigu difficile à réaliser.

La figure 6b montre une troisième géométrie possible pour chaque pièce magnétique de chaque concentrateur de flux. La figure 6b montre ainsi un concentrateur de flux 31_CF comportant une première pièce magnétique 31_PM1 et une deuxième pièce magnétique 31_PM2 ayant la troisième géométrie. La première pièce magnétique 31_PM1 présente :

- un premier côté ou grand côté 31_PM1_Lo1 suivant l'axe X ;
- un deuxième côté ou petit côté 31_PM1_Lo2 suivant l'axe X ;
- un côté 31_PM1_La1 suivant l'axe Y ;
- un premier côté 31_PM1_Ch1 chanfreiné suivant la direction XY ;
- un deuxième côté 31_PM1_Ch2 chanfreiné reliant le deuxième côté 31_PM1_Lo2 suivant l'axe X et le premier côté 31_PM1_Ch1 chanfreiné suivant la direction XY.

De manière analogue, la deuxième pièce magnétique 31_PM2 présente :

- un premier côté ou grand côté 31_PM2_Lo1 suivant l'axe X ;
- un deuxième côté ou petit côté 31_PM2_Lo2 suivant l'axe X ;
- un côté 31_PM2_La1 suivant l'axe Y ;
- un premier côté 31_PM2_Ch1 chanfreiné suivant la direction XY ;
- un deuxième côté 31_PM2_Ch2 chanfreiné reliant le deuxième côté 31_PM2_Lo2 suivant l'axe X et le premier côté 31_PM2_Ch1 chanfreiné suivant la direction XY.

Le deuxième côté 31_PM1_Ch2 de la première pièce magnétique 31_PM1 est typiquement sensiblement parallèle au deuxième côté 31_PM2_Ch2 de la deuxième pièce magnétique 31_PM2.

Dans la troisième géométrie, la présence d'un deuxième côté chanfreiné dans chaque pièce magnétique contribue avantageusement, pour un champ magnétique appliqué suivant la grande dimension du concentrateur de flux, à encore augmenter la concentration et l'amplification du flux au sein de l'entrefer.

La figure 6c montre une quatrième géométrie possible pour chaque pièce magnétique de chaque concentrateur de flux. La figure 6c montre ainsi un concentrateur de flux 41_CF comportant une première pièce magnétique 41_PM1 et une deuxième pièce magnétique 41_PM2 ayant la quatrième géométrie. La première pièce magnétique 41_PM1 présente :

- un premier côté ou grand côté 41_PM1_Lo1 suivant l'axe X ;
- un deuxième côté ou petit côté 41_PM1_Lo2 suivant l'axe X ;
- un premier côté ou grand côté 41_PM1_La1 suivant l'axe Y ;
- un deuxième côté ou petit côté 41_PM1_La2 suivant l'axe Y ;
- un premier côté 41_PM1_Ch1 chanfreiné suivant la direction XY ;
- un deuxième côté 41_PM1_Ch2 chanfreiné reliant le petit côté 41_PM1_Lo2 suivant l'axe X et le petit côté 41_PM1_La2 suivant l'axe Y.

De manière analogue, la deuxième pièce magnétique 41_PM2 présente :

- un premier côté ou grand côté 41_PM2_Lo1 suivant l'axe X ;
- un deuxième côté ou petit côté 41_PM2_Lo2 suivant l'axe X ;
- un premier côté ou grand côté 41_PM2_La1 suivant l'axe Y ;
- un deuxième côté ou petit côté 41_PM2_La2 suivant l'axe Y ;
- un premier côté 41_PM2_Ch1 chanfreiné suivant la direction XY ;
- un deuxième côté 41_PM2_Ch2 chanfreiné reliant le petit côté 41_PM1_Lo2 suivant l'axe X et le petit côté 41_PM1_La2 suivant l'axe Y.

La quatrième géométrie combine avantageusement les avantages des deuxième et troisième géométries, c'est-à-dire une facilité de fabrication accrue et une augmentation de l'amplification du champ formé au sein de l'entrefer pour un champ appliqué orienté suivant la grande dimension du concentrateur de flux.

La figure 6d montre une cinquième géométrie possible pour chaque pièce magnétique de chaque concentrateur de flux. La figure 6d montre ainsi un concentrateur de flux 51_CF comportant une première pièce magnétique 51_PM1 et une deuxième pièce magnétique 51_PM2 ayant la cinquième géométrie. La première pièce magnétique 51_PM1 présente :

- un côté 51_PM1_La suivant l'axe Y ;
- un premier côté 51_PM1_Ch1 chanfreiné suivant la direction XY ;
- un deuxième côté 51_PM1_Ch2 chanfreiné reliant une première extrémité du côté 51_PM1_Lo2 suivant l'axe Y à une première extrémité du premier côté 51_PM1_Ch1 chanfreiné suivant la direction XY ;
- un troisième côté 51_PM1_Ch3 chanfreiné reliant une deuxième extrémité du côté 51_PM1_Lo2 suivant l'axe Y à une deuxième extrémité du premier côté 51_PM1_Ch1 chanfreiné suivant la direction XY.

Un deuxième aspect de l'invention concerne un capteur de champ magnétique 100 pour la détection d'au moins trois composantes de champ magnétique.

Le capteur magnétique 100 comporte :

- le capteur de champ magnétique 10 précédemment décrit, qui comprend le premier capteur 11 pour la détection d'une première composante magnétique suivant le premier axe X et le deuxième capteur 12 pour la détection d'une deuxième composante magnétique suivant le deuxième axe Y ;
- un troisième capteur 13 pour la détection d'une troisième composante magnétique suivant un troisième axe Z distinct du premier axe X et du deuxième axe Y.

Le troisième capteur 13 comporte :

- un troisième concentrateur de flux 13_CF, comprenant une première pièce magnétique 13_PM1, une deuxième pièce magnétique 13_PM2 et un entrefer 13_E entre les première et deuxième pièces magnétiques ;
- un premier élément magnétorésistif 13_MR agencé dans l'entrefer 13_E du premier concentrateur de flux 13_CF ;
- un premier contact électrique 13_ct1 et un deuxième contact électrique 13_ct2 ;
- avantageusement, un premier aimant permanent 13_A1 et un deuxième aimant permanent 13_A2 (non représentés mais référencés pour une meilleure clarté) agencés de part et d'autre du premier élément magnétorésistif 13_MR.

Le troisième concentrateur de flux 13_CF présente une première dimension 13_D1 dite «grande dimension » suivant une direction sensiblement perpendiculaire à la troisième direction Z, et une deuxième dimension 13_D2 dite « petite dimension » suivant une direction sensiblement parallèle à la direction XY. Le troisième axe Z est hors du plan OXY défini par le premier axe X et par le deuxième axe Y. Le troisième axe Z est préférentiellement sensiblement perpendiculaire au plan OXY. Plus l'angle formé entre le plan OXY et le troisième axe Z est proche de 90°, plus la sensibilité du troisième capteur 13 à la composante magnétique suivant le troisième axe Z augmente, et plus la sensibilité du troisième capteur 13 aux composantes magnétiques suivant le premier axe X et le deuxième axe Y diminue. Si le troisième axe Z n'est pas perpendiculaire au plan OXY, le troisième capteur 13 pour la détection de la composante magnétique suivant le troisième axe Z est également sensible, dans une moindre mesure, aux composantes magnétiques suivant le premier axe X et suivant le deuxième axe Y. Le troisième élément magnétorésistif 13_MR est du même type que le premier élément magnétorésistif 11_MR et que le deuxième élément magnétorésistif 12_MR, c'est-à-dire par exemple qu'ils sont tous les trois des vannes de spin, ou tous les trois des jonctions tunnels magnétiques, ou tous les trois des éléments à anisotropie de magnétorésistance. Le premier élément magnétorésistif 11_MR, le deuxième élément magnétorésistif 12_MR et le troisième élément magnétorésistif 13_MR sont en outre avantageusement réalisés à partir des mêmes matériaux. De manière analogue aux premier et deuxième éléments magnétorésistifs 11_MR et 12_MR précédemment décrits, le troisième élément magnétorésistif 13_MR comporte :

- une couche de référence ayant une direction d'aimantation fixe 13_Mref, et
- une couche sensible ayant une direction d'aimantation variable 13_Mvar.

La direction d'aimantation variable 13_Mvar de la couche sensible du troisième élément magnétorésistif est avantageusement polarisée transversalement par rapport à la direction d'aimantation fixe 13_Mref de la couche de référence du troisième élément magnétorésistif, grâce aux premier et deuxième aimants permanents agencés de part et d'autre du premier élément magnétorésistif 13_MR, suivant un principe qui a été précédemment décrit en lien avec les premier et deuxième capteurs 11 et 12.

Le capteur de champ magnétique 100 pour la détection d'au moins trois composantes de champ magnétique est préférentiellement fabriqué grâce à un procédé comportant les étapes suivantes, dans cet ordre :

- une première étape 101 de réalisation :

    ◦ du premier capteur 11 sur une face d'une première région Reg1 d'un substrat s'étendant suivant le plan OXY,
    ◦ du deuxième capteur 12 sur une face d'une deuxième région Reg2 du substrat, et
    ◦ du troisième capteur 13 sur une face d'une troisième région Reg3 du substrat ;

- une deuxième étape 102 selon laquelle une première partie de la troisième région Reg3 du substrat, la première partie comportant la face sur laquelle le troisième capteur 13 est réalisé, est séparée du reste du substrat, la première partie faisant saillie du plan de référence OXY.

Grâce à ce procédé de fabrication, les premier, deuxième et troisième capteurs 11, 12 et 13 peuvent être réalisés d'une manière relativement simple, lors d'un même ensemble d'étapes technologiques à la surface d'un même substrat. A l'issue de la première étape 101, les premier, deuxième et troisième capteurs 11, 12 et 13 sont sensiblement dans un même plan. Le troisième capteur 13 est ensuite relevé, lors de la deuxième étape 2, pour faire saillie du plan des premier et deuxième capteurs 11 et 12. A l'issue de la deuxième étape 102, le troisième capteur 13 est hors du plan des premier et deuxième capteurs 11 et 12. A l'issue de la deuxième étape 102, la grande dimension du troisième concentrateur de flux est suivant la direction Z.

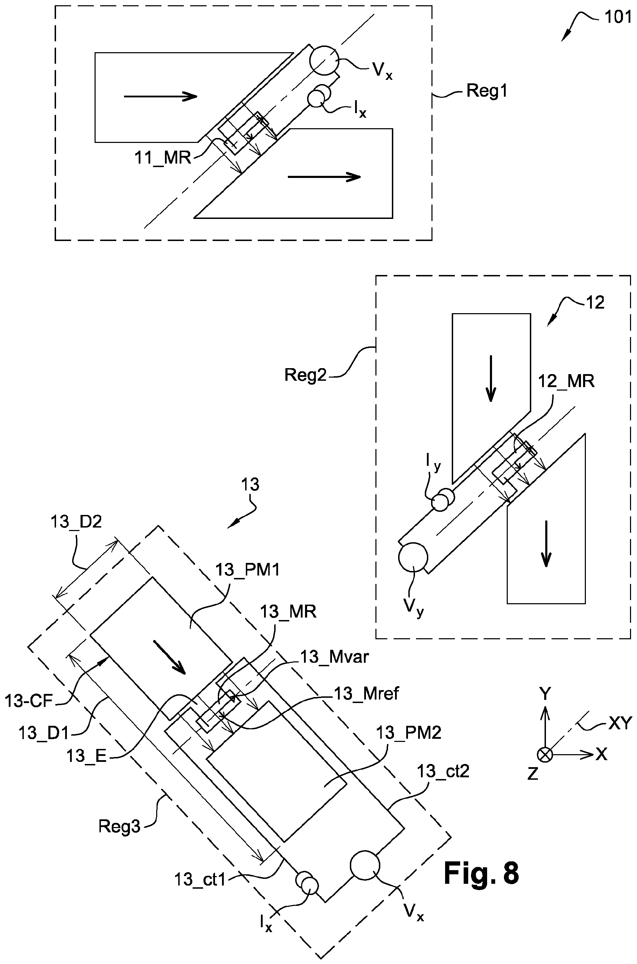

La figure 8 montre schématiquement le capteur de champ magnétique à l'issue de la première étape 101. La figure 8 montre que le premier élément magnétorésistif 11_MR, le deuxième élément magnétorésistif 12_MR et le troisième élément magnétorésistif 13_MR du capteur magnétique 100 présentent la même orientation spatiale dans le plan défini par les axes X et Y : le premier élément magnétorésistif 11_MR, le deuxième élément magnétorésistif 12_MR et le troisième élément magnétorésistif 13_MR sont tous les trois orientés sensiblement parallèlement à la direction XY. Le deuxième élément magnétorésistif 12_MR est simplement translaté par rapport au premier élément magnétorésistif 11_MR, et de même le troisième élément magnétorésistif 13_MR est simplement translaté par rapport au premier élément magnétorésistif 11_MR. Ainsi, on peut avantageusement définir lors d'une unique étape technologique :

- la direction d'aimantation fixe de la couche de référence du premier élément magnétorésistif 11_MR,
- la direction d'aimantation fixe de la couche de référence du deuxième élément magnétorésistif 12_MR, et
- la direction d'aimantation fixe de la couche de référence du troisième élément magnétorésistif 13_MR.

Pour ce faire, dans le cas où chaque capteur de champ magnétique comporte une couche antiferromagnétique pour le piégeage de la direction d'aimantation fixe de sa couche de référence, on procède par exemple d'une manière analogue au procédé qui a été précédemment décrit dans le cas du capteur de champ magnétique 10 :

- la couche antiferromagnétique du premier capteur 11, la couche antiferromagnétique du deuxième capteur 12 et la couche antiferromagnétique du troisième capteur 13, qui sont avantageusement réalisées dans le même matériau antiferromagnétique et ont donc la même température de blocage, sont chauffées à une température excédant la température de blocage.
- Tout en maintenant une température excédant la température de blocage, la direction d'aimantation de la couche de référence du premier capteur, la direction d'aimantation de la couche de référence du deuxième capteur et la direction d'aimantation de la couche de référence du troisième capteur sont définies simultanément par l'application d'un champ orienté dans la direction souhaitée.
- Le chauffage est arrêté tout en maintenant l'application du champ orienté dans la direction souhaitée.
- L'application du champ orienté dans la direction souhaitée est arrêtée lorsque la couche antiferromagnétique du premier capteur 11, la couche antiferromagnétique du deuxième capteur 12 et la couche antiferromagnétique du troisième capteur 13 ont à nouveau une température inférieure à leur température de blocage.

On a précédemment expliqué que chacun des premier, deuxième et troisième capteurs 11, 12 et 13 comporte avantageusement des premier et deuxième aimants permanents qui polarisent la direction d'aimantation variable de la couche de référence de chaque capteur. Les premier et deuxième aimants permanents du troisième capteur 13 sont avantageusement réalisés dans un matériau identique au matériau des premier et deuxième aimants permanents du deuxième capteur 12 et au matériau des premier et deuxième aimants permanents du premier capteur 11. On permet ainsi avantageusement leur fabrication simultanée. La direction d'aimantation des premier et deuxième aimants permanents du troisième capteur 13 est avantageusement identique à la direction d'aimantation des premier et deuxième aimants permanents du deuxième capteur 12 et à la direction d'aimantation des premier et deuxième aimants permanents du premier capteur 11. Ainsi, la direction d'aimantation des aimants permanents des premier, deuxième et troisième capteurs 11, 12 et 13 est avantageusement définie et obtenue lors d'une seule et même étape technologique. Cette étape technologique unique consiste typiquement, comme précédemment décrit, en l'application d'un fort champ magnétique, supérieur au champ coercitif du matériau des aimants permanents, orienté dans la direction souhaitée. L'application de ce fort champ magnétique induit dans chaque aimant permanent une aimantation rémanente dans la direction désirée. Dans l'exemple représenté à la figure 8, la direction d'aimantation des aimants permanents des premier, deuxième et troisième capteurs 11, 12 et 13 est définie sensiblement parallèlement à la direction XY.

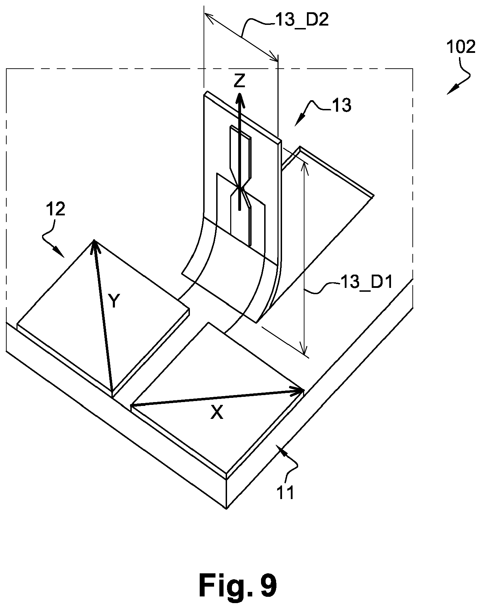

La figure 9 montre schématiquement le capteur de champ magnétique à l'issue de la deuxième étape 102. A l'issue de la deuxième étape 102, le premier concentrateur de flux 11_CF, le deuxième concentrateur de flux 12_CF et le troisième concentrateur de flux 13_CF ne présentent pas la même orientation spatiale : le premier concentrateur de flux 11_CF a sa grande dimension suivant l'axe X, le deuxième concentrateur de flux 12_CF a sa grande dimension suivant l'axe Y et le troisième concentrateur de flux 13_CF a sa grande dimension suivant l'axe Z. La géométrie et l'orientation de chaque concentrateur de flux contribuent à déterminer l'axe de sensibilité de chaque capteur uniaxial.

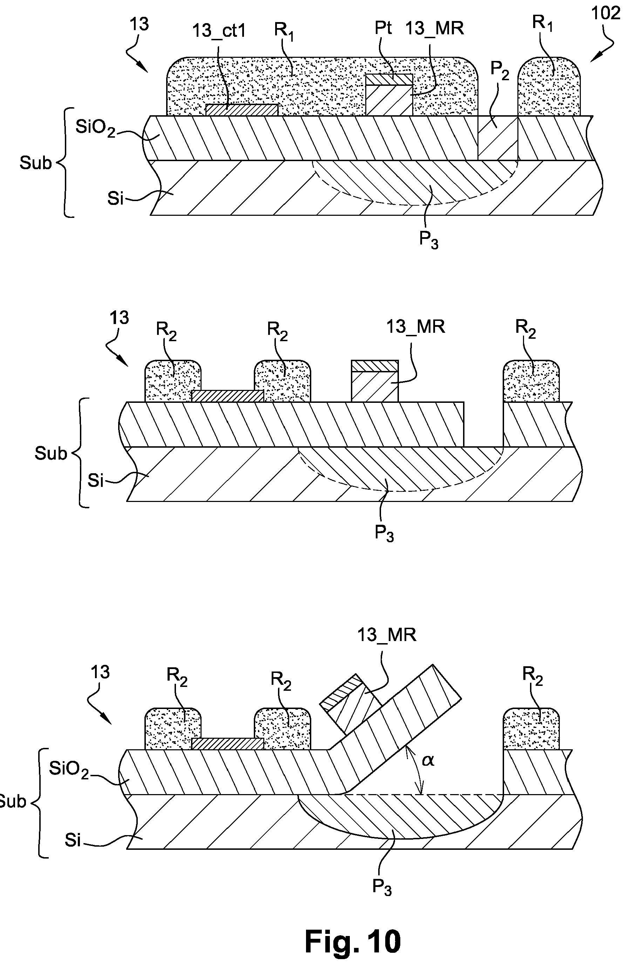

La figure 10 montre schématiquement un exemple de réalisation de la deuxième étape 102 permettant de « libérer » le troisième capteur 13 afin qu'il fasse saillie hors du plan des premier et deuxième capteurs 11 et 12.

La deuxième étape 102 peut par exemple être réalisée par une gravure anisotrope sèche par plasma, ou humide par chimie, d'une deuxième partie P2 et par une gravure isotrope sèche par plasma ou humide par chimie d'une troisième partie P3 de la troisième région Reg3 du substrat. Le substrat est référencé Sub sur la figure 10. Dans l'exemple de la figure 10, le substrat Sub comporte une première couche en Si et une deuxième couche, qui s'étend sur la première couche, en SiO2. La deuxième partie P2 entoure partiellement la première partie comportant la face sur laquelle le troisième capteur 13 est réalisé. La deuxième partie P2 est typiquement dans la deuxième couche en SiO2 du substrat Sub. La troisième partie P3 se situe en face opposée à la face sur laquelle le troisième capteur 13 est réalisé. La troisième partie P3 est typiquement dans la première couche en Si du substrat Sub.

Pour ce faire, une résine R1, par exemple de type HS15-12, est déposée, à l'issue de la première étape 101, sur l'ensemble du dispositif en dehors de la zone P2. Cette deuxième zone P2 sera supprimée par une gravure anisotrope du SIO2. La résine R1 sera ensuite retirée et une nouvelle résine R2 par exemple de type SU-8 sera déposée sur les zones à préserver et ouverte sur les contacts car cette résine sera conservée dans le dispositif final.

La résine R2 peut alternativement être une résine photosensible autre que le SU-8, ou un polymère structurant, ou un oxyde métallique. On réalise ensuite une gravure isotrope de la troisième partie P3 en Si, l'élément magnétorésistif étant protégé par exemple par une couche de platine de 100nm d'épaisseur. La première région Reg1 et la deuxième région Reg2 du substrat ne sont pas gravées.

A l'issue de la deuxième étape 102, après que le troisième capteur 13 s'est soulevé, par relâchement des contraintes, hors du plan dans lequel il a initialement été fabriqué, on procède avantageusement à une étape d'encapsulation du troisième capteur 13. L'étape d'encapsulation est par exemple réalisée en fixant le troisième capteur 13 dans un polymère ou dans un oxyde. L'étape d'encapsulation du troisième capteur 13 peut ainsi être réalisée par évaporation, croissance, spray ou dépôt d'un oxyde ou d'un polymère. En « noyant » ainsi le troisième capteur 13 relevé dans un matériau qui le fige, on évite avantageusement que l'orientation du troisième capteur 13 ne change, par exemple sous l'effet de chocs ou même de variations de température, ce qui modifierait la réponse en champ du troisième capteur 13.

D'une manière comparable à ce qui a été précédemment décrit en lien avec la figure 7, on cherche généralement à travailler dans le régime linéaire de fonctionnement de chaque élément magnétorésistif du capteur de champ magnétique 100. Dans ce régime linéaire de fonctionnement, la tension V aux bornes de chaque élément magnétorésistif varie linéairement en fonction du champ B agissant sur l'élément magnétorésistif :

$$V = \propto B$$

Le champ B agissant sur chaque élément magnétorésistif est le champ dans l'entrefer du concentrateur de flux du capteur considéré. Lorsque l'on se trouve dans le régime de perméabilité linéaire du matériau des pièces magnétiques des concentrateurs de flux, on a :

$$B = a_x B_x + a_y B_y + a_z B_z$$

où $a_y$ est le facteur d'amplification du concentrateur de flux considéré suivant la direction Y et $B_z$ est la composante du champ appliqué suivant la direction Z.

Dans l'exemple représenté à la figure 8, le premier concentrateur de flux 11_CF présente préférentiellement un fort facteur d'amplification suivant la direction X et un faible facteur d'amplification suivant les directions Y et Z ; le deuxième concentrateur de flux 12_CF présente un fort facteur d'amplification suivant la direction Y et un faible facteur d'amplification suivant les directions X et Z ; et le troisième concentrateur de flux 13_CF présente un fort facteur d'amplification suivant la direction Z et un faible facteur d'amplification suivant les directions X et Y.

Dans son régime linéaire de fonctionnement, le premier élément magnétorésistif 11_MR délivre une première tension de sortie V11 telle que :

$$V11 = \propto_{11} a_{11x} B_x + \propto_{11} a_{11y} B_y + \propto_{11} a_{11z} B_z$$

où $a_{11z}$ est le facteur d'amplification du premier concentrateur de flux 11_CF suivant la direction Z.

De même, le deuxième élément magnétorésistif 12_MR délivre en régime linéaire une deuxième tension de sortie V12 telle que :

$$V12 = \propto_{12} a_{12x} B_x + \propto_{12} a_{12y} B_y + \propto_{12} a_{12z} B_z$$

où $a_{12z}$ est le facteur d'amplification du deuxième concentrateur de flux 12_CF suivant la direction Z.

Enfin, le troisième élément magnétorésistif 13_MR délivre en régime linéaire une troisième tension de sortie V13 telle que :

$$V13 = \propto_{13} a_{13x} B_x + \propto_{13} a_{13y} B_y + \propto_{13} a_{13z} B_z$$

où $\alpha_{13}$ est le coefficient linéaire du régime linéaire du troisième élément magnétorésistif, $a_{13x}$ est le facteur d'amplification du troisième concentrateur de flux 13_CF suivant la direction X, $a_{13y}$ est le facteur d'amplification du troisième concentrateur de flux 13_CF suivant la direction Y et $a_{13z}$ est le facteur d'amplification du troisième concentrateur de flux 13_CF suivant la direction Z.

Les trois équations précédentes peuvent s'écrire sous forme matricielle :

$$\begin{bmatrix} V11 \\ V12 \\ V13 \end{bmatrix} = M' \begin{bmatrix} Bx \\ By \\ Bz \end{bmatrix}$$

avec :

$$M' = \begin{bmatrix} \propto_{11} a_{11x} & \propto_{11} a_{11y} & \propto_{11} a_{11z} \\ \propto_{12} a_{12x} & \propto_{12} a_{12y} & \propto_{12} a_{12z} \\ \propto_{13} a_{13x} & \propto_{13} a_{13y} & \propto_{13} a_{13z} \end{bmatrix}$$

Dans la matrice M', les coefficients dominants sont les termes diagonaux, mais les termes non-diagonaux ne sont pas forcément négligeables.

En inversant la matrice M, on peut donc remonter aux première, deuxième et troisième composantes du champ à partir des mesures de tension :

$$\begin{bmatrix} Bx \\ By \\ Bz \end{bmatrix} = M^{-1} \begin{bmatrix} V11 \\ V12 \\ V13 \end{bmatrix}$$

De même que la matrice M précédemment décrite, la matrice M' est établie lors de la fabrication, par étalonnage du premier capteur 11, du deuxième capteur 12 et du troisième capteur 13 soumis successivement à un champ suivant X, à un champ suivant Y et à un champ suivant Z.

**Revendications**

1. Capteur de champ magnétique (10) pour la détection d'au moins deux composantes de champ magnétique comportant :

   - un premier capteur (11) pour la détection d'une première composante magnétique suivant une première direction X comprenant :

     ◦ un premier concentrateur de flux (11_CF) comportant une première pièce magnétique (11_PM1), une deuxième pièce magnétique (11_PM2) et un entrefer (11_E) entre les première et deuxième pièces magnétiques ;
     ◦ un premier élément magnétorésistif (11_MR) agencé dans l'entrefer (11_E) du premier concentrateur de flux (11_CF),

   - un deuxième capteur (12) pour la détection d'une deuxième composante magnétique suivant une deuxième direction Y distincte de la première direction X comprenant :

     ◦ un deuxième concentrateur de flux (12_CF) comportant une première pièce magnétique (12_PM1), une deuxième pièce magnétique (12_PM2) et un entrefer (12_E) entre les première et deuxième pièces magnétiques ;

◦ un deuxième élément magnétorésistif (12_MR) agencé dans l'entrefer (12_E) du deuxième concentrateur de flux (12_CF) ;

chacun des premier et deuxième éléments magnétorésistifs (11_MR, 12_MR) comportant une couche de référence ayant une direction d'aimantation fixe (11_Mref, 12_Mref) et une couche sensible ayant une direction d'aimantation variable (11_Mvar, 12_Mvar), chacun des premier et deuxième éléments magnétorésistifs ayant un premier état dit « état de repos » dans lequel l'aimantation de la couche sensible a une première direction donnée, et un deuxième état dit « état excité » dans lequel l'aimantation de la couche sensible a une deuxième direction distincte de la première direction ;

ledit capteur de champ magnétique (12) étant **caractérisé en ce que** :

- la direction d'aimantation fixe (11_Mref) de la couche de référence du premier élément magnétorésistif (11_MR) est sensiblement identique à la direction d'aimantation fixe (12_Mref) de la couche de référence du deuxième élément magnétorésistif (12_MR) ;
- lorsque les premier et deuxième éléments magnétorésistifs (11_MR, 12_MR) sont dans le premier état de repos, la direction d'aimantation variable (11_Mvar) de la couche sensible du premier élément magnétorésistif (11_MR) est sensiblement identique à la direction d'aimantation variable (12_Mvar) de la couche sensible du deuxième élément magnétorésistif ;
- l'entrefer (11_E) du premier concentrateur de flux (11_CF) et l'entrefer (12_E) du deuxième concentrateur de flux (12_CF) sont orientés parallèlement à une direction XY qui est, à $\pm 15°$, et avantageusement à $\pm 5°$, la bissectrice de la première direction X et de la deuxième direction Y ;
- le premier élément magnétorésistif (11_MR) comporte une première couche antiferromagnétique pour le piégeage de la direction d'aimantation fixe (11_Mref) de la couche de référence du premier élément magnétorésistif, le deuxième élément magnétorésistif (12_MR) comporte une deuxième couche antiferromagnétique pour le piégeage de la direction d'aimantation fixe (12_Mref) de la couche de référence du deuxième élément magnétorésistif, et la première couche antiferromagnétique et la deuxième couche antiferromagnétique ont une même température de blocage ;
- chaque pièce magnétique de chaque concentrateur de flux présente une première dimension et une deuxième dimension inférieure à la première dimension et chacun des premier et deuxième concentrateurs de flux (11_CF, 12_CF) présente une première dimension (11_D1, 12_D1) et une deuxième dimension (11_D2, 12_D2) inférieure à la première dimension, la deuxième dimension de chaque concentrateur de flux étant supérieure ou égale à la deuxième dimension de chacune de ses pièces magnétiques, le premier concentrateur de flux (11_CF) et chaque pièce magnétique du premier concentrateur de flux ayant leur première dimension suivant la première direction X et leur deuxième dimension suivant la deuxième direction Y, le deuxième concentrateur de flux (12_CF) et chaque pièce magnétique du deuxième concentrateur de flux ayant leur première dimension suivant la deuxième direction Y et leur deuxième dimension suivant la première direction X.

2. Capteur de champ magnétique (10) selon la revendication précédente **caractérisé en ce que** la deuxième direction Y est sensiblement perpendiculaire à la première direction X.

3. Capteur de champ magnétique (10) selon l'une quelconque des revendications précédentes **caractérisé en ce que** :

- le premier capteur (11) comporte un premier aimant permanent (11_A1) et un deuxième aimant permanent (11_A2) agencés de part et d'autre du premier élément magnétorésistif (11_MR), lesdits premier et deuxième aimants permanents ayant une même direction d'aimantation (11_Hbias) polarisant l'aimantation (11_Mvar) de la couche sensible du premier élément magnétorésistif (11_MR) et déterminant la première direction d'aimantation de ladite couche sensible lorsque le premier élément magnétorésistif (11_MR) est au repos, et
- le deuxième capteur (12) comporte un premier aimant permanent (12_A1) et un deuxième aimant permanent (12_A2) agencés de part et d'autre du deuxième élément magnétorésistif (12_MR), lesdits premier et deuxième aimants permanents ayant une même direction d'aimantation (12_Hbias) polarisant l'aimantation (12_Mvar) de la couche sensible du deuxième élément magnétorésistif (12_MR) et déterminant la première direction d'aimantation de ladite couche sensible lorsque le deuxième élément magnétorésistif (12_MR) est au repos, la direction d'aimantation (11_Hbias) des premier et deuxième aimants permanents (11_A1, 11_A2) du premier capteur (11) étant sensiblement identique à la direction d'aimantation (12_Hbias) des premier et deuxième aimants permanents (12_A1, 12_A2) du deuxième capteur (12).

4.  Capteur de champ magnétique (10) selon l'une quelconque des revendications précédentes **caractérisé en ce que** :

    - chacun des premier et deuxième concentrateurs de flux (11_CF, 12_CF) présente une première dimension (11_D1, 12_D1), dite «grande dimension », et une deuxième dimension (11_D2, 12_D2), dite «petite dimension », inférieure à la première dimension,
    - la grande dimension (11_D1) du premier concentrateur de flux (11_CF) est suivant la première direction X et la petite dimension (11_D2) du premier concentrateur de flux (11_CF) est suivant la deuxième direction Y,
    - la grande dimension (12_D1) du deuxième concentrateur de flux (12_CF) est suivant la deuxième direction Y et la petite dimension (12_D2) du deuxième concentrateur de flux (12_CF) est suivant la première direction X.

5.  Capteur de champ magnétique (10) selon l'une des revendications précédentes **caractérisé en ce que** les premier et deuxième capteurs ont leur élément magnétorésistif constitué des mêmes matériaux.

6.  Capteur de champ magnétique selon l'une quelconque des revendications précédentes **caractérisé en ce que** chaque pièce magnétique (21_PM1, 21_PM2) de chaque concentrateur de flux (21_CF) présente un côté chanfreiné (21_PM1_Ch, 21_PM2_Ch).

7.  Capteur de champ magnétique (10) selon la revendication précédente **caractérisé en ce que** le côté chanfreiné de chaque pièce magnétique (11_PM1, 11_PM2, 12_PM1, 12_PM2) de chaque concentrateur de flux (11_CF, 12_CF) est un côté biseauté (11_PM1_Ch, 11_PM2_Ch, 12_PM1_Ch, 12_PM2_Ch).

8.  Capteur de champ magnétique selon l'une quelconque des revendications précédentes **caractérisé en ce que** chaque pièce magnétique (41_PM1, 41_PM2) de chaque concentrateur de flux (41_CF) présente le côté chanfreiné (41_PM1_Ch1, 41_PM2_Ch1) et un deuxième côté chanfreiné (41_PM1_Ch2, 41_PM2_Ch2).

9.  Capteur de champ magnétique selon la revendication précédente **caractérisé en ce que** le deuxième côté chanfreiné est un deuxième côté biseauté (31_PM1_Ch2, 31_PM2_Ch2).

10. Capteur de champ magnétique (100) pour la détection d'au moins trois composantes de champ magnétique **caractérisé en ce qu'**il comporte :

    - le capteur de champ magnétique (10) pour la détection d'au moins deux composantes de champ magnétique selon l'une quelconque des revendications 1 à 9, et
    - un troisième capteur (13) pour la détection d'une troisième composante magnétique suivant une troisième direction Z distincte de la première direction X et de la deuxième direction Y comprenant :

      ○ un troisième concentrateur de flux (13_CF) comportant une première pièce magnétique (13_PM1), une deuxième pièce magnétique (13_PM2) et un entrefer (13_E) entre les premières et deuxième pièces magnétiques ;
      ○ un troisième élément magnétorésistif (13_MR) agencé dans l'entrefer (13_E) du troisième concentrateur de flux (13_CF) ;

    le troisième concentrateur de flux (13_CF) présentant une première dimension dite « grande dimension » suivant une direction sensiblement parallèle à la troisième direction Z, et une deuxième dimension dite « petite dimension » suivant une direction sensiblement parallèle à la direction XY des premier et deuxième capteurs.

11. Capteur de champ magnétique (100) pour la détection d'au moins trois composantes de champ magnétique selon la revendication précédente **caractérisé en ce que** les éléments magnétorésistifs des premier, deuxième et troisième capteurs sont constitués des mêmes matériaux avec des directions de leur couche de référence et de leur couche sensible au repos sensiblement identiques.

12. Procédé de fabrication d'un capteur de champ magnétique (100) pour la détection d'au moins trois composantes de champ magnétique selon la revendication 10 ou la revendication 11 comportant les étapes suivantes :

    - une étape (101) de réalisation du premier capteur (11) sur une face d'une première région (Reg1) d'un substrat, de réalisation du deuxième capteur (12) sur une face d'une deuxième région (Reg2) du substrat et de réalisation du troisième capteur (13) sur une face d'une troisième région (Reg3) du substrat, ledit substrat s'étendant suivant un plan de référence OXY, la première direction X et la deuxième direction Y étant parallèles au plan de référence OXY ;

- une étape (102) selon laquelle une première partie de la troisième région (Reg3) du substrat est séparée du reste du substrat, la première partie comportant la face sur laquelle le troisième capteur (13) est réalisé et la première partie faisant saillie du plan de référence OXY.

13. Procédé de fabrication selon la revendication 12 **caractérisé en ce que** la première partie de la troisième région (Reg3) du substrat qui fait saillie du plan de référence OXY s'étend sensiblement suivant un plan perpendiculaire au plan de référence OXY.

14. Procédé de fabrication selon l'une quelconque des revendications 12 ou 13 **caractérisé en ce que** la première partie de la troisième région (Reg3) du substrat est séparée du reste du substrat par une étape de gravure d'une deuxième partie (P2) et d'une troisième partie (P3) de la troisième région du substrat.

15. Procédé d'écriture de la direction d'aimantation des couches de référence dans un capteur de champ magnétique (10) selon l'une quelconque des revendications 1 à 9 ou dans un capteur de champ magnétique (100) selon la revendication 10 ou la revendication 11 dans lequel la direction d'aimantation fixe de la couche de référence de chaque élément magnétorésistif est piégée par une couche antiferromagnétique, chaque couche antiferromagnétique de piégeage ayant une même température de blocage, le procédé comportant les étapes suivantes :

- chauffage simultané des couches antiferromagnétiques de piégeage à une température supérieure à la température de blocage ;
- lorsque les couches antiferromagnétiques de piégeage ont une température supérieure à la température de blocage, application simultanée aux couches antiferromagnétiques de piégeage d'un champ d'écriture orienté suivant une direction souhaitée pour l'aimantation des couches de référence ;
- arrêt du chauffage tout en maintenant l'application du champ d'écriture aux couches antiferromagnétiques de piégeage ;
- lorsque les couches antiferromagnétiques de piégeage ont retrouvé une température inférieure à la température de blocage, arrêt de l'application du champ d'écriture.

**Patentansprüche**

1. Magnetfeldsensor (10) für die Erfassung von wenigstens zwei Magnetfeldkomponenten, umfassend:

- einen ersten Sensor (11) für die Erfassung einer ersten magnetischen Komponente gemäß einer ersten Richtung X, umfassend:

  ◦ einen ersten Stromkonzentrator (11_CF), umfassend ein erstes magnetisches Teil (11_PM1), ein zweites magnetisches Teil (11_PM2) und einen Luftspalt (11_E) zwischen dem ersten und zweiten magnetischen Teil;
  ◦ ein erstes magnetisches Widerstandselement (11_MR), das in dem Luftspalt (11_E) des ersten Stromkonzentrators (11_CF) angeordnet ist;

- einen zweiten Sensor (12) für die Erfassung einer zweiten magnetischen Komponente gemäß einer zweiten Richtung Y, die von der ersten Richtung X unterschiedlich ist, umfassend:

  ◦ einen zweiten Stromkonzentrator (12_CF), umfassend ein erstes magnetisches Teil (12_PM1), ein zweites magnetisches Teil (12_PM2) und einen Luftspalt (12_E) zwischen dem ersten und zweiten magnetischen Teil;
  ◦ ein zweites magnetisches Widerstandselement (12_MR), das in dem Luftspalt (12_E) des zweiten Stromkonzentrators (12_CF) angeordnet ist;

wobei jedes erste und zweite magnetische Widerstandselement (11_MR, 12_MR) eine Referenzschicht umfasst, die eine feste Magnetisierungsrichtung (11_Mref, 12_Mref) hat und eine sensible Schicht umfasst, die eine variable Magnetisierungsrichtung (11_Mvar, 12_Mvar) hat, wobei jedes erste und zweite magnetische Widerstandselement einen ersten Zustand hat, bezeichnet als "Ruhezustand", in dem die Magnetisierung der sensiblen Schicht eine erste bestimmte Richtung hat, und einen zweiten Zustand hat, bezeichnet als "erregter Zustand", in dem die Magnetisierung der sensiblen Schicht eine zweite, von der ersten Richtung unterschiedliche Richtung hat; wobei der genannte Magnetfeldsensor (12) **dadurch gekennzeichnet ist, dass**:

- die feste Magnetisierungsrichtung (11_Mref) der Referenzschicht des ersten magnetischen Widerstandselements (11_MR) deutlich identisch mit der festen Magnetisierungsschicht (12_Mref) der Referenzschicht des zweiten magnetischen Widerstandselements (12_MR) ist;
- wenn das erste und zweite magnetische Widerstandselement (11_MR, 12_MR) sich im ersten Ruhezustand befinden, ist die variable Magnetisierungsrichtung (11_Mvar) der sensiblen Schicht des ersten magnetischen Widerstandselements (11_MR) deutlich mit der variablen Magnetisierungsrichtung (12_Mvar) der sensiblen Schicht des zweiten magnetischen Widerstandselements identisch;
- der Luftspalt (11_E) des ersten Stromkonzentrators (11_CF) und der Luftspalt (12_E) des zweiten Stromkonzentrators (12_CF) parallel zu einer Richtung XY ausgerichtet sind, die bei +/- 15° und vorteilhaft +/- 5° die Halbierungslinie der ersten Richtung X und der zweiten Richtung Y ist;
- das erste magnetische Widerstandselement (11_MR) eine erste antiferromagnetische Schicht zum Einfangen der festen Magnetisierungsrichtung (11_Mref) der Referenzschicht des ersten magnetischen Widerstandselements umfasst, das zweite magnetische Widerstandselement (12_MR) eine zweite antiferromagnetische Schicht zum Einfangen der festen Magnetisierungsrichtung (12_Mref) der Referenzschicht des zweiten magnetischen Widerstandselements umfasst und die erste antiferromagnetische Schicht und die zweite antiferromagnetische Schicht eine und dieselbe Blockiertemperatur haben;
- jedes magnetische Teil jedes Stromkonzentrators eine erste Abmessung und eine zweite Abmessung aufweist, die kleiner ist als die erste Abmessung und jeder erste und zweite Stromkonzentrator (11_CF, 12_CF) eine erste Abmessung (11_D1, 12_D1) und eine zweite Abmessung (11_D2, 12_D2) aufweist, die kleiner ist als die erste Abmessung, wobei die zweite Abmessung jedes Stromkonzentrators größer als die oder gleich der zweite(n) Abmessung jedes magnetischen Teils ist, wobei der erste Stromkonzentrator (11_CF) und jedes ihrer magnetische Teile des ersten Stromkonzentrators ihre erste Abmessung gemäß der ersten Richtung X und ihre zweite Abmessung gemäß der zweiten Richtung Y hat, wobei der zweite Stromkonzentrator (12_CF) und jedes magnetische Teil des zweiten Stromkonzentrators ihre erste Abmessung gemäß der zweiten Richtung Y und ihre zweite Abmessung gemäß der ersten Richtung X haben.

2. Magnetfeldsensor (10) gemäß dem voranstehenden Anspruch, **dadurch gekennzeichnet, dass** die zweite Richtung Y deutlich lotrecht zur ersten Richtung X ist.

3. Magnetfeldsensor (10) gemäß irgendeinem der voranstehenden Ansprüche, **dadurch gekennzeichnet, dass**:

- der erste Sensor (11) einen ersten Dauermagneten (11_A1) und einen zweiten Dauermagneten (11_A2) umfasst, die auf jeder Seite des ersten magnetischen Widerstandselements (11_MR) angeordnet sind, wobei der genannte erste und zweite Dauermagnet eine und dieselbe Magnetisierungsrichtung (11_Hbias) haben, die die Magnetisierung (11_Mvar) der sensiblen Schicht des ersten magnetischen Widerstandselements (11_MR) polarisiert und die erste Magnetisierungsschicht der genannten sensiblen Schicht bestimmt, wenn das erste magnetische Widerstandselement (11_MR) im Ruhezustand ist, und
- der zweite Sensor (12) einen ersten Dauermagneten (12_A1) und einen zweiten Dauermagneten (12_A2) umfasst, die auf jeder Seite des zweiten magnetischen Widerstandselements (12_MR) angeordnet sind, wobei der genannte erste und zweite Dauermagnet eine und dieselbe Magnetisierungsrichtung (12_Hbias) haben, die die Magnetisierung (12_Mvar) der sensiblen Schicht des zweiten magnetischen Widerstandselements (12_MR) polarisiert und die erste Magnetisierungsrichtung der genannten sensiblen Schicht bestimmt, wenn das zweite magnetische Widerstandselement (12_MR) im Ruhezustand ist;
wobei die Magnetisierungsrichtung (11_Hbias) des ersten und zweiten Dauermagneten (11_A1, 11_A2) des ersten Sensors (11) deutlich identisch mit der Magnetisierungsrichtung (12_Hbias) des ersten und zweiten Dauermagneten (12_A1, 12_A2) des zweiten Sensors (12) ist.

4. Magnetfeldsensor (10) gemäß irgendeinem der voranstehenden Ansprüche, **dadurch gekennzeichnet, dass**:

- jeder erste und zweite Stromkonzentrator (11_CF, 12_CF) eine erste Abmessung (11_D1, 12_D1), bezeichnet als "große Abmessung", und eine zweite Abmessung (11_D2, 12_D2), bezeichnet als "kleine Abmessung", die kleiner ist als die erste Abmessung, aufweist,
- die große Abmessung (11_D1) des ersten Stromkonzentrators (11_CF) gemäß der ersten Richtung X ist und die kleine Abmessung (11_D2) des ersten Stromkonzentrators (11_CF) gemäß der zweiten Richtung Y ist,
- die große Abmessung (12_D1) des zweiten Stromkonzentrators (12_CF) gemäß der zweiten Richtung Y ist und die kleine Abmessung (12_D) des zweiten Stromkonzentrators (12_CF) gemäß der ersten Richtung X ist.

**5.** Magnetfeldsensor (10) gemäß irgendeinem der voranstehenden Ansprüche, **dadurch gekennzeichnet, dass** der erste und zweite Sensor ihr magnetisches Widerstandselement haben, das aus denselben Materialien gebildet ist.

**6.** Magnetfeldsensor gemäß irgendeinem der voranstehenden Ansprüche, **dadurch gekennzeichnet, dass** jedes magnetische Teil (21_PM1, 21_PM2) jedes Stromkonzentrators (21_CF) eine abgefaste Seite (21_PM1_Ch, 21_PM2_Ch) aufweist.

**7.** Magnetfeldsensor (10) gemäß dem voranstehenden Anspruch, **dadurch gekennzeichnet, dass** die abgefaste Seite jedes magnetischen Teils (11_PM1, 11_PM2, 12_PM1, 12_PM2) jedes Stromkonzentrators (11_CF, 12_CF) eine abgeschrägte Seite (11_PM1_Ch, 11_PM2_Ch, 12_PM1_Ch, 12_PM2_CH2) ist.

**8.** Magnetfeldsensor gemäß irgendeinem der voranstehenden Ansprüche, **dadurch gekennzeichnet, dass** jedes magnetische Teil (41_PM1, 41_PM2) jedes Stromkonzentrators (41_CF) die abgefaste Seite (41_PM1_CH1, 41_PM2 Ch1) und eine zweite abgefaste Seite (41_PM1_CH2, 41_PM2_Ch2) aufweist.

**9.** Magnetfeldsensor gemäß dem voranstehenden Anspruch, **dadurch gekennzeichnet, dass** die zweite abgefaste Seite eine zweite abgeschrägte Seite (31_PM1_Ch2, 31_PM2_Ch2) ist.

**10.** Magnetfeldsensor (100) für die Erfassung von wenigstens drei Magnetfeldkomponenten, **dadurch gekennzeichnet, dass** er umfasst:

- den Magnetfeldsensor (10) für die Erfassung von wenigstens zwei Magnetfeldkomponenten gemäß irgendeinem der Ansprüche 1 bis 9, und
- einen dritten Sensor (13) für die Erfassung einer dritten magnetischen Komponente gemäß einer dritten Richtung Z, die von der ersten Richtung X und der zweiten Richtung Y unterschiedlich ist, umfassend:

  ◦ einen dritten Stromkonzentrator (13_CF), umfassend ein erstes magnetisches Teil (13_PM1), ein zweites magnetisches Teil (13_PM2) und einen Luftspalt (13_E) zwischen dem ersten und zweiten magnetischen Teil;
  ◦ ein drittes magnetisches Widerstandselement (13_MR), das in dem Luftspalt (13_E) des dritten Stromkonzentrators (13_CF) angeordnet ist;

wobei der dritte Stromkonzentrator (13_CF) eine erste Abmessung, bezeichnet als "große Abmessung" gemäß einer zur dritten Richtung Z deutlich parallelen Richtung, und eine zweite Abmessung, bezeichnet als "kleine Abmessung" gemäß einer zur Richtung XY des ersten und zweiten Sensors deutlich parallelen Richtung aufweist.

**11.** Magnetfeldsensor (100) für die Erfassung von wenigstens drei Magnetfeldkomponenten gemäß dem voranstehenden Anspruch, **dadurch gekennzeichnet, dass** die magnetischen Widerstandselemente des ersten, zweiten und dritten Sensors aus denselben Materialien mit Richtungen ihrer Referenzschicht und ihrer sensiblen Schicht in der Ruhestellung gebildet sind, die deutlich identisch sind.

**12.** Fertigungsverfahren eines Magnetfeldsensors (100) für die Erfassung von wenigstens drei Magnetfeldkomponenten gemäß Anspruch 10 oder Anspruch 11, umfassend die folgenden Schritte:

- einen Realisierungsschritt (101) des ersten Sensors (11) auf einer Seite einer ersten Region (Reg1) eines Substrats, der Realisierung des zweiten Sensors (12) auf einer Seite einer zweiten Region (Reg2) des Substrats und der Realisierung des dritten Sensors (13) auf einer Seite einer dritten Region (Reg3) des Substrats, wobei sich das genannte Substrat sich gemäß einer Referenzebene OXY erstreckt, wobei die erste Richtung X und die zweite Richtung Y parallel zur Referenzebene OXY sind;
- einen Schritt (102) gemäß dem ein erster Teil der dritten Region (Reg3) des Substrats von dem Rest des Substrats getrennt ist, wobei das erste Teil die Seite umfasst, auf der der dritte Sensor (13) realisiert ist, und das erste Teil aus der Referenzebene OXY hervorsteht.

**13.** Fertigungsverfahren gemäß Anspruch 12, **dadurch gekennzeichnet, dass** das erste Teil der dritten Region (Reg3) des Substrats, das aus der Referenzebene OXY hervorsteht, sich deutlich gemäß einer zur Referenzebene OXY lotrechten Ebene erstreckt.

**14.** Fertigungsverfahren gemäß irgendeinem der Ansprüche 12 oder 13, **dadurch gekennzeichnet, dass** das erste Teil der dritten Region (Reg3) des Substrats von dem Rest des Substrats durch eine Gravurschicht eines zweiten Teils (P2) und einen dritten Teil (P3) der dritten Region des Substrats getrennt ist.

15. Schreibverfahren der Magnetisierungsrichtung der Referenzschichten in einem Magnetfeldsensor (10) gemäß irgendeinem der Ansprüche 1 bis 9 o-der in einem Magnetfeldsensor (100) gemäß Anspruch 10 oder Anspruch 11, in dem die feste Magnetisierungsrichtung der Referenzschicht jedes magnetischen Widerstandselements durch eine antiferromagnetische Schicht eingefangen ist, wobei jede antiferromagnetische Einfangschicht eine und dieselbe Blockiertemperatur hat, wobei das Verfahren die folgenden Schritte umfasst:

- gleichzeitiges Erhitzen der antiferromagnetischen Einfangschichten bei einer höheren Temperatur als der Blockiertemperatur;
- wenn die antiferromagnetischen Einfangschichten eine höhere Temperatur als die Blockiertemperatur haben, die gleichzeitige Anwendung eines Schriftfeldes, das gemäß einer für die Magnetisierung der Referenzschichten gewünschten Richtung ausgerichtet ist, auf die antiferromagnetischen Einfangschichten;
- Abschaltung des Erhitzens bei gleichzeitiger Aufrechterhaltung der Anwendung des Schriftfeldes auf die antiferromagnetischen Einfangschichten;
- wenn die antiferromagnetischen Einfangschichten wieder eine Temperatur erreicht haben, die niedriger ist als die Blockiertemperatur, Abschaltung der Anwendung des Schriftfeldes.

**Claims**

1. Magnetic field sensor (10) for the detection of at least two magnetic field components comprising:

   - a first sensor (11) for the detection of a first magnetic component according to a first direction X comprising:

     ◦ a first flux concentrator (11_CF) comprising a first magnetic part (11_PM1), a second magnetic part (11_PM2) and a gap (11_E) between the first and second magnetic parts;
     ◦ a first magnetoresistive element (11_MR) arranged in the gap (11_E) of the first flux concentrator 11_CF),

   - a second sensor (12) for the detection of a second magnetic component according to a second direction Y separate from the first direction X comprising:

     ◦ a second flux concentrator (12_CF) comprising a first magnetic part (12_PM1), a second magnetic part (12_PM2) and a gap (12_E) between the first and second magnetic parts;
     ◦ a second magnetoresistive element (12_MR) arranged in the gap (12_E) of the second flux concentrator (12_CF);

   with each one of the first and second magnetoresistive elements (11_MR, 12_MR) comprising a reference layer having a fixed magnetization direction (11_Mref, 12_Mref) and a sensitive layer having a variable magnetization direction (11_Mvar, 12_Mvar), with each one of the first and second magnetoresistive elements having a first state referred to as "at rest" wherein the magnetization of the sensitive layer has a given first direction, and a second state referred to as "excited state" wherein the magnetization of the sensitive layer has a second direction separate from the first direction;
   said magnetic field sensor (12) being **characterised in that**:

   - the fixed magnetization direction (11_Mref) of the reference layer of the first magnetoresistive element (11_MR) is substantially identical to the fixed magnetization direction (12_Mref) of the reference layer of the second magnetoresistive element (12_MR);
   - when the first and second magnetoresistive elements (11_MR, 12_MR) are in the first at rest state, the variable magnetization direction (11_Mvar) of the sensitive layer of the first magnetoresistive element (11_MR) is substantially identical to the variable magnetization direction (12_Mvar) of the sensitive layer of the second magnetoresistive element;
   - the gap (11_E) of the first flux concentrator (11_CF) and the gap (12_E) of the second flux concentrator (12_CF) are oriented parallel to a direction XY which is, at ±15°, and advantageously at ±5°, the bisector of the first direction X and of the second direction Y;
   - the first magnetoresistive element (11_MR) comprises a first antiferromagnetic layer for the trapping of the fixed magnetization direction (11_Mref) of the reference layer of the first magnetoresistive element, the second magnetoresistive element (12_MR) comprises a second antiferromagnetic layer for the trapping of the fixed magnetization direction (12_Mref) of the reference layer of the second magnetoresistive element, and the first antiferromagnetic layer and the second antiferromagnetic layer have the same blocking temperature;
- each magnetic part of each flux concentrator has a first dimension and a second dimension less than the first dimension and each one of the first and second flux concentrators (11_CF, 12_CF) has a first dimension (11_D1, 12_D1) and a second dimension (11_D2, 12_D2) less than the first dimension, the second dimension of each flux concentrator being greater than or equal to the second dimension of each one of its magnetic parts, with the first flux concentrator (11_CF) and each magnetic part of the first flux concentrator having their first dimension according to the first direction X and their second dimension according to the second direction Y, with the second flux concentrator (12_CF) and each magnetic part of the second flux concentrator having their first dimension according to the second direction Y and their second dimension according to the first direction X.

2. Magnetic field sensor (10) as claimed in the preceding claim **characterised in that** the second direction Y is substantially perpendicular to the first direction X.

3. Magnetic field sensor (10) as claimed in any preceding claim **characterised in that**:

- the first sensor (11) comprises a first permanent magnet (11_A1) and a second permanent magnet (11_A2) arranged on either side of the first magnetoresistive element (11_MR), with said first and second permanent magnets having a same magnetization direction (11_Hbias) polarising the magnetization (11_Mvar) of the sensitive layer of the first magnetoresistive element (11_MR) and determining the first magnetization direction of said sensitive layer when the first magnetoresistive element (11_MR) is at rest, and
- the second sensor (12) comprises a first permanent magnet (12_A1) and a second permanent magnet (12_A2) arranged on either side of the second magnetoresistive element (12_MR), with said first and second permanent magnets having a same magnetization direction (12_Hbias) polarising the magnetization (12_Mvar) of the sensitive layer of the second magnetoresistive element (12_MR) and determining the first magnetization direction of said sensitive layer when the second magnetoresistive element (12_MR) is at rest,
with the magnetization direction (11_Hbias) of the first and second permanent magnets (11_A1, 11_A2) of the first sensor (11) being substantially identical to the magnetization direction (12_Hbias) of the first and second permanent magnets (12_A1, 12_A2) of the second sensor (12).

4. Magnetic field sensor (10) as claimed in any preceding claim **characterised in that**:

- each one of the first and second flux concentrators (11_CF, 12_CF) has a first dimension (11_D1, 12_D1 ), referred to as "large dimension", and a second dimension (11_D2, 12_D2), referred to as "small dimension", less than the first dimension,
- the large dimension (11_D1) of the first flux concentrator (11_CF) is according to the first direction X and the small dimension (11_D2) of the first flux concentrator (11_CF) is according to the second direction Y,
- the large dimension (12_D1) of the second flux concentrator (12_CF) is according to the second direction Y and the small dimension (12_D2) of the second flux concentrator (12_CF) is according to the first direction X.

5. Magnetic field sensor (10) according to one of the preceding claims **characterised in that** the first and second sensors have their magnetoresistive element constituted of the same materials.

6. Magnetic field sensor as claimed in any preceding claim **characterised in that** each magnetic part (21_PM1, 21_PM2) of each flux concentrator (21_CF) has a chamfered side (21_PM1_Ch, 21_PM2_Ch).

7. Magnetic field sensor (10) as claimed in the preceding claim **characterised in that** the chamfered side of each magnetic part (11_PM1, 11_PM2, 12_PM1, 12_PM2) of each flux concentrator (11_CF, 12_CF) is a bevelled side (11_PM1_Ch, 11_PM2_Ch, 12_PM1_Ch, 12_PM2_Ch).

8. Magnetic field sensor as claimed in any preceding claim **characterised in that** each magnetic part (41_PM1, 41_PM2) of each flux concentrator (41_CF) has the chamfered side (41_PM1_Ch1, 41_PM2_Ch1) and a second chamfered side (41_PM1_Ch2, 41_PM2_Ch2).

9. Magnetic field sensor as claimed in the preceding claim **characterised in that** the second chamfered side is a second bevelled side (31_PM1_Ch2, 31_PM2_Ch2).

**10.** Magnetic field sensor (100) for the detection of at least three magnetic field components **characterised in that** it comprises:

- the magnetic field sensor (10) for the detection of at least two magnetic field components according to any of claims 1 to 9, and
- a third sensor (13) for the detection of a third magnetic component according to a third direction Z separate from the first direction X and from the second direction Y comprising:

o a third flux concentrator (13_CF) comprising a first magnetic part (13_PM1), a second magnetic part (13_PM2) and a gap (13_E) between the first and second magnetic parts;
o a third magnetoresistive element (13_MR) arranged in the gap (13_E) of the third flux concentrator (13_CF);

the third flux concentrator (13_CF) having a first dimension referred to as "large dimension" according to a direction substantially parallel to the third direction Z, and a second dimension referred to as "small dimension" according to a direction substantially parallel to the direction XY of the first and second sensors.

**11.** Magnetic field sensor (100) for the detection of at least three magnetic field components as claimed in the preceding claim **characterised in that** the magnetoresistive elements of the first, second and third sensors are constituted of the same materials with directions of their reference layer and of their sensitive layer at rest substantially identical.

**12.** Method for manufacturing a magnetic field sensor (100) for the detection of at least three magnetic field components according to claim 10 or claim 11 comprising the following steps:

- a step (101) of carrying out the first sensor (11) on a face of a first region (Reg1) of a substrate, of carrying out the second sensor (12) on a face of a second region (Reg2) of the substrate and of carrying out the third sensor (13) on a face of a third region (Reg3) of the substrate, said substrate extending according to a reference plane OXY, with the first direction X and the second direction Y being parallel to the reference plane OXY;
- a step (102) according to which a first portion of the third region (Reg3) of the substrate is separated from the rest of the substrate, with the first portion comprising the face whereon the third sensor (13) is carried out and the first portion is protruding from the reference plane OXY.

**13.** Method of manufacturing according to claim 12 **characterised in that** the first portion of the third region (Reg3) of the substrate which protrudes from the reference plane OXY extends substantially according to a plane perpendicular to the reference plane OXY.

**14.** Method of manufacturing according to any of claims 12 or 13 **characterised in that** the first portion of the third region (Reg3) of the substrate is separated from the rest of the substrate by a step of etching of a second portion (P2) and of a third portion (P3) of the third region of the substrate.

**15.** Method of writing the magnetization direction of the reference layers in a magnetic field sensor (10) according to any of claims 1 to 9 or in a magnetic field sensor (100) according to claim 10 or claim 11 wherein the fixed magnetization direction of the reference layer of each magnetoresistive element is trapped by an antiferromagnetic layer, with each antiferromagnetic trapping layer having the same blocking temperature, with the method comprising the following steps:

- simultaneous heating of the antiferromagnetic trapping layers at a temperature greater than the blocking temperature;
- when the antiferromagnetic trapping layers have a temperature greater than the blocking temperature, simultaneous application to the antiferromagnetic trapping layers of a field for writing oriented according to a desired direction for the magnetization of the reference layers;
- stopping of the heating while still maintaining the application of a field for writing on the antiferromagnetic trapping layers;
- when the antiferromagnetic trapping layers have returned to a temperature less than the blocking temperature, stopping of the application of the field for writing.

L2

CF

1

PM1

X

Y

MR
H_bias

B

E

H_bias

A1

A2

M_ref

M_var

L1

ct1

ct2

**Fig. 1**

PM2

1-x

CF-x

PM1-x

MR-x
Hbias-x

B-x

E-x

Hbias-x

A1-x

A2-x

Mref-x

Mvar-x

PM2-x

ct1-x

ct2-x

ct1-y

Hbias-y
Mref-y

A1-y
E-y

B-y

1-y

PM2-y

Mvar-y

PM1-y

Hbias-y

A2-y

ct2-y

CF-y

X

Y

**Fig. 2**

**Fig. 3a**

EP 3 009 853 B1

Fig. 3b

EP 3 009 853 B1

**Fig. 4a**

11_D1

11_PM1_Lo2

11_PM1_La

11_PM1_Ch

XY

11_CF

11_PM2_Lo1

-11_PM1-

11_D2

-11_PM2-

11_PM2_La

11_PM1_Lo1

11_PM2_Ch

11_E

Y

11_PM2_Lo2

X

**Fig. 4b**

11'_D1

11'_PM1_Lo2

11'_PM1_La

11'_PM1_Ch

11'_CF

11'_PM2_Lo1

-11'_PM1-

11'_D2

-11'_PM2-

11'_PM2_La

11'_PM1_Lo1

11'_E

11'_PM2_Ch

Y

XY

11'_PM2_Lo2

X

**Fig. 4c**

**Fig. 5a**

**Fig. 5b**

Fig. 6a

Fig. 6b

Fig. 6c

51_PM1_Ch2

51_PM1_Ch1

51_CF

51_PM2_Ch3

51_PM1_La

-51_PM1-

XY

51_PM2_La

-51_PM2-

51_PM1_Ch3

51_PM2_Ch1

Y

X

51_PM2_Ch2

**Fig. 6d**

$V$

$V_{max}$

0

$V_{min}$

B

0

**Fig. 7**

Fig. 8

Fig. 9

**Fig. 10**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2011309829 A1

- US 2014021571 A1

**Littérature non-brevet citée dans la description**

- Fully integrated three-axis Hall magnetic sensor based on micromachined structures. **SILEO L et al.** MICROELECTRONIC ENGINEERING. ELSEVIER PUBLISHERS BV, 01 Mai 2010, vol. 87, 1217-1219